# EUROPEAN PATENT APPLICATION

(11) **EP 4 343 815 A1**
(43) Date of publication of application: **27.03.2024**
(21) Application number: 23197753.9
(22) Date of filing: 15.09.2023
(51) Int. Cl.: H01L 21/02, H01L 21/32

(54) **METHOD OF PROCESSING SUBSTRATE, METHOD OF MANUFACTURING SEMICONDUCTOR DEVICE, SUBSTRATE PROCESSING SYSTEM, AND PROGRAM**

(30) Priority: 26.09.2022 JP 2022153086
(71) Applicant: Kokusai Electric Corp., Tokyo 1010045 (JP)
(72) Inventor: NAKATANI, Kimihiko, Toyama, 9392393 (JP)
(74) Representative: Bardehle Pagenberg Partnerschaft mbB Patentanwälte Rechtsanwälte

(57) **Abstract**

There is provided a technique that includes: (a) forming a first inhibitor layer on a first surface of the substrate having the first surface and a second surface by supplying a first modifying agent to the substrate; (b) forming a first film on the second surface by supplying a first film-forming agent to the substrate; (c) forming a second film on the first film by supplying a second film-forming agent to the substrate, wherein a film including at least one selected from the group of the first film and the second film has been formed on the first surface; (d) removing the film by supplying an etching agent to the substrate; (e) forming a second inhibitor layer on the first surface by supplying a second modifying agent to the substrate; and (f) forming a third film on the second film by supplying a third film-forming agent to the substrate.

## Description

### CROSS-REFERENCE TO RELATED APPLICATION

This application is based upon and claims the benefit of priority from Japanese Patent Application No. 2022-153086, filed on September 26, 2022, the entire contents of which are incorporated herein by reference.

### TECHNICAL FIELD

The present disclosure relates to a method of processing a substrate, a method of manufacturing a semiconductor device, a substrate processing system, and a program.

### BACKGROUND

As a process of manufacturing a semiconductor device, a process of forming a film by selectively allowing the film to grow on a specific surface among a plurality of types of surfaces in which materials exposed on a surface of a substrate are different (hereinafter, this process is also referred to as selective growth or selective film formation) may be often carried out.

With the miniaturization of semiconductor devices, there is a strong demand to selectively form a film with high precision when performing the selective growth.

### SUMMARY

Some embodiments of the present disclosure provide a technique capable of selectively forming a film on a desired surface with high precision.

According to embodiments of the present disclosure, there is provided a technique that includes: (a) forming a first inhibitor layer on a first surface of the substrate having the first surface and a second surface by supplying a first modifying agent, which reacts with the first surface, to the substrate; (b) forming a first film on the second surface by supplying a first film-forming agent, in which a first energy is imparted to at least a portion of the first film-forming agent, to the substrate; (c) forming a second film on the first film formed on the second surface by supplying a second film-forming agent, in which a second energy is imparted to at least a portion of the second film-forming agent, to the substrate, wherein a film including at least one selected from the group of the first film and the second film has been formed on the first surface; (d) removing the film formed on the first surface by supplying an etching agent to the substrate; (e) forming a second inhibitor layer on the first surface after the film has been removed, by supplying a second modifying agent, which reacts with the first surface, to the substrate; and (f) forming a third film on the second film on the first film formed on the second surface by supplying a third film-forming agent, in which a third energy is imparted to at least a portion of the third film-forming agent, to the substrate.

### BRIEF DESCRIPTION OF DRAWINGS

The accompanying drawings, which are incorporated in and constitute a part of the specification, illustrate embodiments of the present disclosure.
FIG. 1 is a schematic configuration view of a vertical process furnace of a substrate processing apparatus suitably used in embodiments of the present disclosure, in which a portion of the process furnace is shown in a vertical cross section.
FIG. 2 is a schematic configuration view of the vertical process furnace of the substrate processing apparatus suitably used in embodiments of the present disclosure, in which a portion of the process furnace is shown in a cross section taken along line A-A in FIG. 1.
FIG. 3 is a schematic configuration diagram of a controller of a substrate processing apparatus suitably used in embodiments of the present disclosure, in which a control system of the controller is shown in a block diagram.
FIG. 4A is a schematic cross-sectional view showing a surface portion of a wafer having a first surface and a second surface.
FIG. 4B is a schematic cross-sectional view showing a surface portion of the wafer after a first inhibitor layer is selectively formed on the first surface by performing step A from the state of FIG. 4A.
FIG. 4C is a schematic cross-sectional view showing a surface portion of the wafer after a first film is selectively formed on the second surface by performing step B from the state of FIG. 4B.
FIG. 4D is a schematic cross-sectional view showing a surface portion of the wafer after a second film is formed on the first film formed on the second surface by performing step C from the state of FIG. 4C, and a second film thinner than the second film formed on the first film is locally formed on the first surface.
FIG. 4E is a schematic cross-sectional view showing a surface portion of the wafer after the second film locally formed on the first surface is removed by performing step D from the state of FIG. 4D.
FIG. 4F is a schematic cross-sectional view showing a surface portion of the wafer after a second inhibitor layer is selectively formed on the first surface by performing step E from the state of FIG. 4E.
FIG. 4G is a schematic cross-sectional view showing a surface portion of the wafer after a third film is formed on the second film on the first film formed on the second surface by performing step F from the state of FIG. 4F.
FIG. 4H is a schematic cross-sectional view showing a surface portion of the wafer after heat treatment is performed to the wafer including the first film, the second film, and the third film formed on the second surface by performing step H from the state of FIG. 4G and at that time, the second inhibitor layer formed on the first surface is removed.
FIG. 5A is a schematic cross-sectional view showing a surface portion of a wafer having a first surface and a second surface.
FIG. 5B is a schematic cross-sectional view showing a surface portion of the wafer after a first inhibitor layer is selectively formed on the first surface by performing step A from the state of FIG. 5A.
FIG. 5C is a schematic cross-sectional view showing a surface portion of the wafer after a first film is selectively formed on the second surface by performing step B from the state of FIG. 5B, and a first film thinner than the first film formed on the second surface is locally formed on the first surface.
FIG. 5D is a schematic cross-sectional view showing a surface portion of the wafer after the first film locally formed on the first surface is removed by performing step I from the state of FIG. 5C.
FIG. 5E is a schematic cross-sectional view showing a surface portion of the wafer after a first inhibitor layer is selectively re-formed on the first surface by performing step A' from the state of FIG. 5D.
FIG. 5F is a schematic cross-sectional view showing a surface portion of the wafer after a second film is formed on the first film formed on the second surface by performing step C from the state of FIG. 5E, and a second film thinner than the second film formed on the first film is locally formed on the first surface.
FIG. 5G is a schematic cross-sectional view showing a surface portion of the wafer after the second film locally formed on the first surface is removed by performing step D from the state of FIG. 5F.
FIG. 5H is a schematic cross-sectional view showing a surface portion of the wafer after a second inhibitor layer is selectively formed on the first surface by performing step E from the state of FIG. 5G.
FIG. 5I is a schematic cross-sectional view showing a surface portion of the wafer after a third film is formed on the second film on the first film formed on the second surface by performing step F from the state of FIG. 5H.
FIG. 5J is a schematic cross-sectional view showing a surface portion of the wafer after heat treatment is performed to the wafer including the first film, the second film, and the third film formed on the second surface by performing step H from the state of FIG. 5I, at which time the second inhibitor layer formed on the first surface is removed.
FIG. 6 is a block diagram for explaining an example of a substrate processing system suitably used in another embodiment of the present disclosure.
FIG. 7 is a block diagram for explaining another example of the substrate processing system suitably used in another embodiment of the present disclosure.
FIG. 8 is a graph showing evaluation results in Example 1.
FIG. 9 is a graph showing evaluation results in Example 2.
FIG. 10 is a graph showing evaluation results in Example 3.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

### <Embodiments of the Present Disclosure>

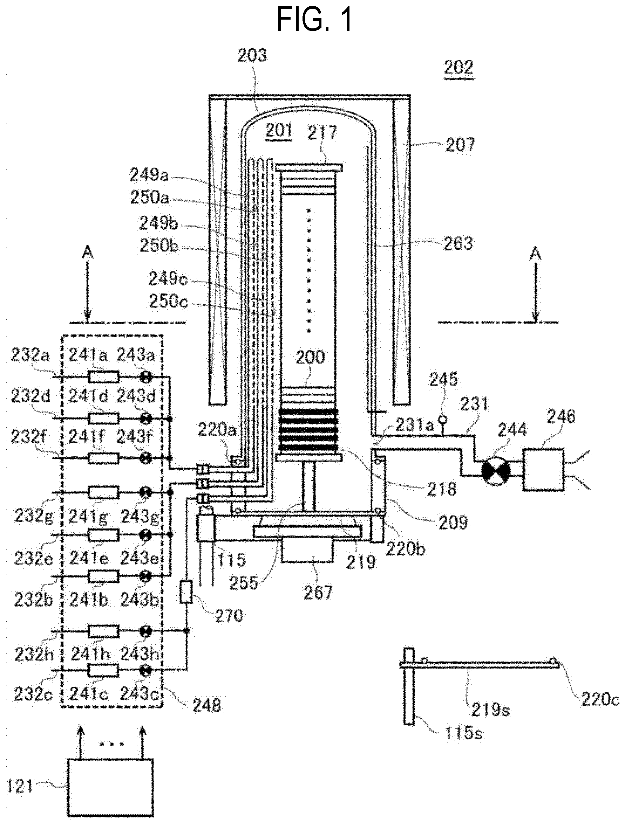

Embodiments of the present disclosure will now be described mainly with reference to FIGS. 1 to 3 and 4A to 4H. The drawings used in the following descriptions are all schematic, and the dimensional relationship, ratios, and the like of various elements shown in figures do not always match the actual ones. Further, the dimensional relationship, ratios, and the like of various elements between plural figures do not always match each other.

### (1) Configuration of Substrate Processing Apparatus (Substrate Processing System)

As shown in FIG. 1, a process furnace 202 includes a heater 207 as a temperature adjustor (a heating part). The heater 207 has a cylindrical shape and is supported by a support plate so as to be vertically installed. The heater 207 functions as an energy imparting part that imparts energy to a gas and also functions as an activation mechanism (an excitation part) when the gas is thermally activated (excited).

A reaction tube 203 is disposed inside the heater 207 to be concentric with the heater 207. The reaction tube 203 is made of, for example, a heat resistant material such as quartz (SiO₂) or silicon carbide (SiC), and has a cylindrical shape with its upper end closed and its lower end opened. A manifold 209 is disposed to be concentric with the reaction tube 203 under the reaction tube 203. The manifold 209 is made of, for example, a metal material such as stainless steel (SUS), and has a cylindrical shape with both of its upper and lower ends opened. The upper end portion of the manifold 209 engages with the lower end portion of the reaction tube 203 so as to support the reaction tube 203. An O-ring 220a serving as a seal member is provided between the manifold 209 and the reaction tube 203. Similar to the heater 207, the reaction tube 203 is vertically installed. A process container (reaction container) mainly includes the reaction tube 203 and the manifold 209. A process chamber 201 is formed in a hollow cylindrical portion of the process container. The process chamber 201 is configured to accommodate a plurality of wafers 200 as substrates. Processing on the wafers 200 is performed in the process chamber 201.

Nozzles 249a to 249c as first to third supply parts are provided in the process chamber 201 so as to penetrate through a sidewall of the manifold 209. The nozzles 249a to 249c are also referred to as first to third nozzles, respectively. The nozzles 249a to 249c are made of, for example, a heat resistant material such as quartz or SiC. Gas supply pipes 232a to 232c are connected to the nozzles 249a to 249c, respectively. The nozzles 249a to 249c are different nozzles, and each of the nozzles 249a and 249c is provided adjacent to the nozzle 249b.

Mass flow controllers (MFCs) 241a to 241c, which are flow rate controllers (flow rate control parts), and valves 243a to 243c, which are opening/closing valves, are installed in the gas supply pipes 232a to 232c, respectively, sequentially from the upstream side of a gas flow. Each of gas supply pipes 232d and 232f is connected to the gas supply pipe 232a at the downstream side of the valves 243a. Each of gas supply pipes 232e and 232g is connected to the gas supply pipe 232b at the downstream side of the valves 243b. A gas supply pipe 232h is connected to the gas supply pipe 232c at the downstream side of the valves 243c. A remote plasma unit (RPU) 270, which is a plasma excitation part (plasma generation part or plasma generator) that excites a gas into a plasma state, is installed at the downstream side of a connection portion of the gas supply pipe 232c with the gas supply pipe 232h. MFCs 241d to 241h and valves 243d to 243h are installed in the gas supply pipes 232d to 232h, respectively, sequentially from the upstream side of a gas flow. The gas supply pipes 232a to 232h are made of, for example, a metal material such as SUS.

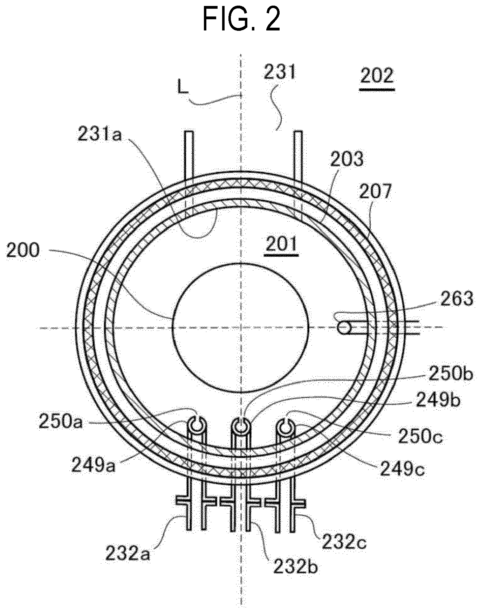

As shown in FIG. 2, each of the nozzles 249a to 249c is arranged in a space having an annular shape in a plane view between an inner wall of the reaction tube 203 and the wafers 200, and is installed so as to extend upward from a lower portion of the inner wall of the reaction tube 203 to an upper portion of the inner wall of reaction tube 203, that is, along an arrangement direction of the wafers 200. Specifically, each of the nozzles 249a to 249c is installed in a region horizontally surrounding a wafer arrangement region, in which the wafers 200 are arranged at a lateral side of the wafer arrangement region, along the wafer arrangement region. In a plan view, the nozzle 249b is arranged so as to face an exhaust port 231a to be described later on a straight line with the centers of the wafers 200 loaded into the process chamber 201, which are interposed therebetween. The nozzles 249a and 249c are arranged so as to sandwich a straight line L passing through the nozzle 249b and the center of the exhaust port 231a from both sides along the inner wall of the reaction tube 203 (the outer peripheral portion of the wafers 200). The straight line L is also a straight line passing through the nozzle 249b and the centers of the wafers 200. That is, it can be said that the nozzle 249c is installed on the side opposite to the nozzle 249a with the straight line L interposed therebetween. The nozzles 249a and 249c are arranged in line symmetry with the straight line L as an axis of symmetry. Gas supply holes 250a to 250c for supplying a gas are formed on the side surfaces of the nozzles 249a to 249c, respectively. Each of the gas supply holes 250a to 250c is opened so as to oppose

(face) the exhaust port 231a in a plan view, which enables a gas to be supplied toward the wafers 200. A plurality of gas supply holes 250a to 250c are formed from the lower portion of the reaction tube 203 to the upper portion of the reaction tube 203.

A first modifying agent and a second modifying agent are supplied from the gas supply pipe 232a into the process chamber 201 via the MFC 241a, the valve 243a, and the nozzle 249a.

A first precursor and a third precursor are supplied from the gas supply pipe 232b into the process chamber 201 via the MFC 241b, the valve 243b, and the nozzle 249b. The first precursor is used as a first film-forming agent. The third precursor is used as a third film-forming agent.

A first reactant, a second reactant, a third reactant, and a fourth reactant are supplied from the gas supply pipe 232c into the process chamber 201 via the MFC 241c, the valve 243c, and the nozzle 249c. The first reactant is used as a first film-forming agent. The second reactant is used a second film-forming agent. The third reactant and the fourth reactant are used as a third film-forming agent.

A second precursor and a catalyst are supplied from the gas supply pipe 232d into the process chamber 201 via the MFC 241d, the valve 243d, the gas supply pipe 232a, and the nozzle 249a. The second precursor is used as a second film-forming agent. The catalyst is used as a third film-forming agent.

A cleaning agent and an etching agent are supplied from the gas supply pipe 232e into the process chamber 201 via the MFC 241e, the valve 243e, the gas supply pipe 232b, and the nozzle 249b.

An inert gas is supplied from the gas supply pipes 232f to 232h into the process chamber 201 via the MFCs 241f to 241h, the valves 243f to 243h, the gas supply pipes 232a to 232c, and the nozzles 249a to 249c, respectively. The inert gas acts as a purge gas, a carrier gas, a dilution gas, or the like.

A remote plasma unit (RPU) 270, which is a plasma excitation part (plasma generation part or plasma generator) that excites a gas into a plasma state, is installed at a downstream side of a connection portion of the gas supply pipe 232c with the gas supply pipe 232h. Exciting a gas into a plasma state is also simply referred to as plasma excitation. By applying radiofrequency (RF) power to the RPU 270, it is possible to plasm-excited a gas inside the RPU 270, that is, to excite the gas into a plasma state. As a plasma generation method, a capacitively-coupled plasma (abbreviation: CCP) method may be used, or an inductively-coupled plasma (abbreviation: ICP) method may be used.

The RPU 270 is configured to be capable of exciting the third reactant supplied from the gas supply pipe 232c into a plasma state and supplying the plasma-excited third reactant into the process chamber 201. Further, the RPU 270 is capable of exciting the first reactant, the second reactant, and the fourth reactant, which are supplied from the gas supply pipe 232c, and the inert gas, which is supplied from the gas supply pipe 232h, into a plasma state and supplying them into the process chamber 201.

A first modifying agent supply system and a second modifying agent supply system are mainly constituted by the gas supply pipe 232a, the MFC 241a, and the valve 243a. A first precursor supply system and a third precursor supply system are mainly constituted by the gas supply pipe 232b, the MFC 241b, and the valve 243b. A first reactant supply system, a second reactant supply system, a third reactant supply system, and a fourth reactant supply system are mainly constituted by the gas supply pipe 232c, the MFC 241c, and the valve 243c. The RPU 270 may be included in the first reactant supply system, the second reactant supply system, the third reactant supply system, and the fourth reactant supply system. A second precursor supply system and a catalyst supply system are mainly constituted by the gas supply pipe 232d, the MFC 241d, and the valve 243d. A cleaning agent supply system and an etching agent supply system are mainly constituted by the gas supply pipe 232e, the MFC 241e, and the valve 243e. An inert gas supply system is mainly constituted by the gas supply pipes 232f to 232h, the MFCs 241f to 241h, and the valves 243f to 243h. Each or both of the first precursor supply system and the first reactant supply system are also referred to as a first film-forming agent supply system. Each or both of the second precursor supply system and the second reactant supply system are also referred to as a second film-forming agent supply system. Each or all of the third precursor supply system, the third reactant supply system, the fourth reactant supply system, and the catalyst supply system are also referred to as a third film-forming agent supply system.

Any or all of the above-described various supply systems may be configured as an integrated-type supply system 248 in which the valves 243a to 243h, the MFCs 241a to 241h, and so on are integrated. The integrated-type supply system 248 is connected to each of the gas supply pipes 232a to 232h. In addition, the integrated-type supply system 248 is configured such that operations of supplying various materials (various gases) into the gas supply pipes 232a to 232h (that is, the opening/closing operation of the valves 243a to 243h, the flow rate adjustment operation by the MFCs 241a to 241h, and the like) are controlled by a controller 121 which will be described later. The integrated-type supply system 248 is configured as an integral type or detachable-type integrated unit, and may be attached to and detached from the gas supply pipes 232a to 232h and the like on an integrated unit basis, so that the maintenance, replacement, extension, etc. of the integrated-type supply system 248 can be performed on an integrated unit basis.

The exhaust port 231a for exhausting an internal atmosphere of the process chamber 201 is installed in the lower portion of the sidewall of the reaction tube 203. As shown in FIG. 2, in a plan view, the exhaust port 231a is installed at a position opposing (facing) the nozzles 249a to 249c (the gas supply holes 250a to 250c) with the wafers 200 interposed therebetween. The exhaust port 231a may be installed to extend from a lower portion of the sidewall of the reaction tube 203 to an upper portion of the side wall of the reaction tube 203, that is, along the wafer arrangement region. An exhaust pipe 231 is connected to the exhaust port 231a. A vacuum exhaust device, for example, a vacuum pump 246, is connected to the exhaust pipe 231 via a pressure sensor 245, which is a pressure detector (pressure detection part) for detecting the internal pressure of the process chamber 201, and an auto pressure controller (APC) valve 244, which is a pressure regulator (pressure adjustment part). The APC valve 244 is configured to perform or stop a vacuum exhaust operation in the process chamber 201 by opening/closing the valve while the vacuum pump 246 is actuated, and is also configured to adjust the internal pressure of the process chamber 201 by adjusting an opening degree of the valve based on pressure information detected by the pressure sensor 245 while the vacuum pump 246 is actuated. An exhaust system is mainly constituted by the exhaust pipe 231, the APC valve 244, and the pressure sensor 245. The vacuum pump 246 may be considered to be included in the exhaust system.

A seal cap 219, which serves as a furnace opening cover configured to hermetically seal a lower end opening of the manifold 209, is installed under the manifold 209. The seal cap 219 is made of, for example, a metal material such as SUS, and is formed in a disc shape. An O-ring 220b, which is a seal member making contact with the lower end of the manifold 209, is installed on an upper surface of the seal cap 219. A rotator 267 configured to rotate a boat 217, which will be described later, is installed under the seal cap 219. A rotary shaft 255 of the rotator 267 is connected to the boat 217 via the seal cap 219. The rotator 267 is configured to rotate the wafers 200 by rotating the boat 217. The seal cap 219 is configured to be vertically moved up and down by a boat elevator 115 which is an elevating mechanism installed outside the reaction tube 203. The boat elevator 115 is configured as a transfer device (transfer mechanism) which loads/unloads (transfers) the wafers 200 into/out of the process chamber 201 by moving the seal cap 219 up and down.

A shutter 219s, which serves as a furnace opening cover configured to hermetically seal a lower end opening of the manifold 209 in a state where the seal cap 219 is lowered and the boat 217 is unloaded from the process chamber 201, is installed under the manifold 209. The shutter 219s is made of, for example, a metal material such as SUS, and is formed in a disc shape. An O-ring 220c, which is a seal member making contact with the lower end of the manifold 209, is installed on an upper surface of the shutter 219s. The opening/closing operation (such as elevation operation, rotation operation, or the like) of the shutter 219s is controlled by a shutter opener/closer 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, a heat resistant material such as quartz or SiC. Heat insulating plates 218 made of, for example, a heat resistant material such as quartz or SiC are installed below the boat 217 in multiple stages.

A temperature sensor 263 serving as a temperature detector is installed in the reaction tube 203. Based on temperature information detected by the temperature sensor 263, a state of supplying electric power to the heater 207 is adjusted such that an interior of the process chamber 201 has a desired temperature distribution. The temperature sensor 263 is installed along the inner wall of the reaction tube 203.

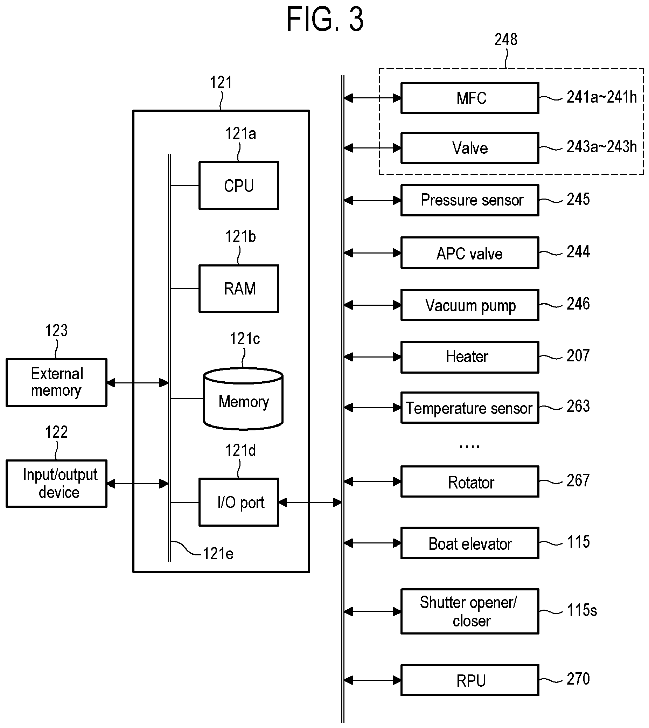

As shown in FIG. 3, a controller 121, which is a control part (control means), is configured as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 formed of, e.g., a touch panel or the like, is connected to the controller 121. Further, an external memory 123 may be connected to the controller 121.

The memory 121c is configured by, for example, a flash memory, a hard disk drive (HDD), a solid state drive (SSD), or the like. A control program for controlling operations of a substrate processing apparatus, a process recipe in which sequences and conditions of substrate processing to be described later are written, and the like are readably stored in the memory 121c. The process recipe functions as a program for causing the controller 121 to execute each sequence in the substrate processing, which will be described later, to obtain an expected result. Hereinafter, the process recipe and the control program may be generally and simply referred to as a "program." Furthermore, the process recipe may be simply referred to as a "recipe." When the term "program" is used herein, it may indicate a case of including the recipe alone, a case of including the control program alone, or a case of including both the recipe and the control program. The RAM 121b is configured as a memory area (work area) in which programs or data read by the CPU 121a are temporarily stored.

The I/O port 121d is connected to the MFCs 241a to 241h, the valves 243a to 243h, the pressure sensor 245, the APC valve 244, the vacuum pump 246, the temperature sensor 263, the heater 207, the rotator 267, the boat elevator 115, the shutter opener/closer 115s, the RPU 270, and so on.

The CPU 121a is configured to read and execute the control program from the memory 121c. The CPU 121a is also configured to read the recipe from the memory 121c according to an input of an operation command from the input/output device 122. The CPU 121a is configured to control the flow rate adjusting operation of various kinds of materials (gases) by the MFCs 241a to 241h, the opening/closing operation of the valves 243a to 243h, the opening/closing operation of the APC valve 244, the pressure adjusting operation performed by the APC valve 244 based on the pressure sensor 245, the actuating and stopping operation of the vacuum pump 246, the temperature adjusting operation performed by the heater 207 based on the temperature sensor 263, the operation of rotating the boat 217 with the rotator 267 and adjusting the rotation speed of the boat 217, the operation of moving the boat 217 up and down by the boat elevator 115, the opening/closing operation of the shutter 219s by the shutter opener/closer 115s, the plasma exciting operation of a gas by the RPU 270, and so on, according to contents of the read recipe.

The controller 121 may be configured by installing, on the computer, the aforementioned program recorded and stored in the external memory 123. Examples of the external memory 123 may include a magnetic disk such as a HDD, an optical disc such as a CD, a magneto-optical disc such as a MO, a semiconductor memory such as a USB memory or a SSD, and the like. The memory 121c or the external memory 123 is configured as a non-transitory computer-readable recording medium. Hereinafter, the memory 121c and the external memory 123 may be generally and simply referred to as a "recording medium". When the term "recording medium" is used herein, it may indicate a case of including the memory 121c only, a case of including the external memory 123 only, or a case of including both the memory 121c and the external memory 123. Furthermore, the program may be provided to the computer using communication means such as the Internet or a dedicated line, instead of using the external memory 123.

### (2) Substrate Processing Process

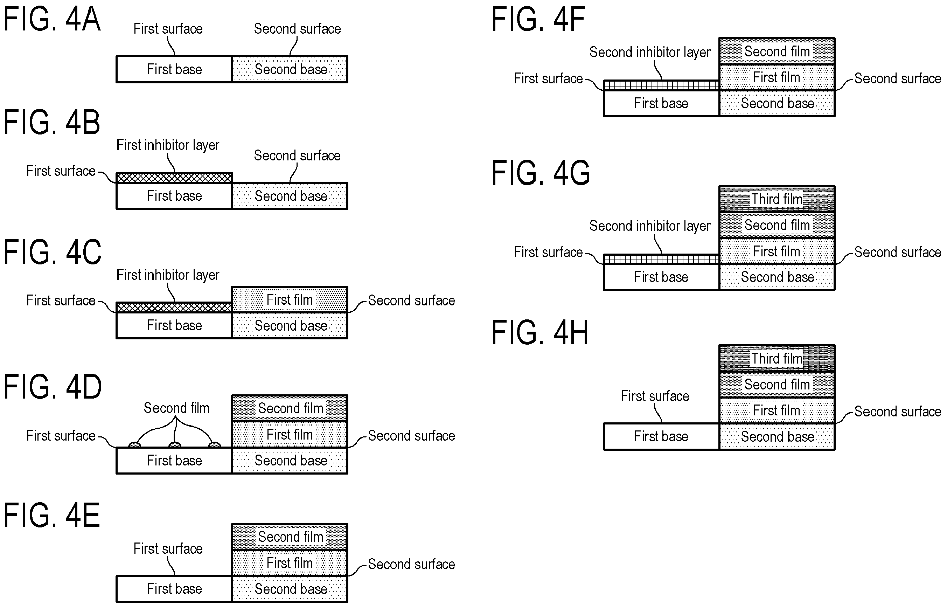

As a process of manufacturing a semiconductor device using the above-described substrate processing apparatus (substrate processing system), an example of a method of processing a substrate, that is, a processing sequence for selectively stacking a first film, a second film, and a third film on a second surface of a wafer 200 as a substrate among a first surface and the second surface of the wafer 200, will be described mainly with reference to FIGS. 4A to 4H. In the following descriptions, the operations of the respective parts constituting the substrate processing apparatus are controlled by the controller 121.

As shown in FIG. 4A, a surface of the wafer 200 has a first base and a second base, a surface of the first base constitutes the first surface, and a surface of the second base constitutes the second surface. In the following descriptions, for the sake of convenience, as a typical example, a case where the first base is a silicon oxide film (SiO₂ film, hereinafter also referred to as a SiO film) as an oxygen-containing film (for example, an oxide film) and the second base is a silicon nitride film (Si₃N₄ film, hereinafter also referred to as a SiN film) as an oxygen-free film (for example, a non-oxide film such as a nitride film) will be described. That is, hereinafter, a case where the first surface is the surface of the SiO film and the second surface is the surface of the SiN film will be described. The first base and the second base are also referred to as a first base film and a second base film, respectively.

A processing sequence in the present embodiment includes:
(a) step A of forming a first inhibitor layer on a first surface of a wafer 200 having the first surface and a second surface by supplying a first modifying agent, which reacts with the first surface, to the wafer 200;
(b) step B of forming a first film on the second surface by supplying a first film-forming agent, in which a first energy is imparted to at least a portion of the first film-forming agent, to the wafer 200;
(c) step C of forming a second film on the first film formed on the second surface by supplying a second film-forming agent, in which a second energy is imparted to at least a portion of the second film-forming agent, to the wafer 200, wherein a film including at least one selected from the group of the first film and the second film has been formed on the first surface;
(d) step D of removing the film formed on the first surface by supplying an etching agent to the wafer 200;
(e) step E of forming a second inhibitor layer on the first surface after the film has been removed, by supplying a second modifying agent, which reacts with the first surface, to the wafer 200; and
(f) step F of forming a third film on the second film on the first film formed on the second surface by supplying a third film-forming agent, in which a third energy is imparted to at least a portion of the third film-forming agent, to the wafer 200.

In the following example, a case of using a first precursor and a first reactant as the first film-forming agent will be described. In this case, the first film-forming agent, in which the first energy is imparted to at least a portion of the first film-forming agent, means that the first energy is imparted to at least one selected from the group of the first precursor and the first reactant. In this case, at least one selected from the group of the first precursor and the first reactant may be excited by the first energy. Further, in the following example, a case of using a second precursor and a second reactant as the second film-forming agent will be described. In this case, the second film-forming agent, in which the second energy is imparted to at least a portion of the second film-forming agent, means that the second energy is imparted to at least one selected from the group of the second precursor and the second reactant. In this case, at least one selected from the group of the second precursor and the second reactant may be excited by the second energy.

Further, in the following example, a case of using a third precursor and a third reactant as the third film-forming agent will be described. It is desirable to further use a catalyst as the third film-forming agent. In this case, the third film-forming agent, the third energy being imparted to at least a portion of the third film-forming agent, means that the third energy is imparted to at least one selected from the group of the third precursor, the third reactant, and the catalyst. In this case, at least one selected from the group of the third precursor, the third reactant, and the catalyst may be excited by the third energy.

Further, in the following example, a case in which step B is performed at a first temperature, step C is performed at a second temperature higher than the first temperature, and step F is performed at a third temperature lower than the second temperature will be described. By controlling the processing temperature as in this case, in step C, the second energy higher than the first energy, which is imparted to the first precursor and the first reactant, is imparted to the second precursor and the second reactant. Further, by controlling the processing temperature as in this case, in step F, the third energy lower than the second energy, which is imparted to the second precursor and the second reactant, is imparted to the third precursor, the third reactant, and the catalyst. In these cases, the first energy is imparted to the first precursor and the first reactant by heating the first precursor and the first reactant at the first temperature, the second energy is imparted to the second precursor and the second reactant by heating the second precursor and the second reactant at the second temperature, and the third energy is imparted to the third precursor and the third reactant by heating the third precursor, the third reactant, and the catalyst at the third temperature.

Further, in the following example, a case in which the first precursor and the first reactant as the first film-forming agent are alternately supplied to the wafer 200 in step B, the second precursor and the second reactant as the second film-forming agent are alternately supplied to the wafer 200 in step C, and the third precursor and catalyst and the third reactant and catalyst as the third film-forming agent are alternately supplied to the wafer 200 in step F. Further, in step F, depending on the process condition, the supply of the catalyst may be omitted.

That is, in the following example, in step B, the first film is formed on the second surface by performing a cycle a predetermined number of times (n₁ times, where n₁ is an integer of 1 or 2 or more), the cycle including step B 1 of supplying the first precursor to the wafer 200 and step B2 of supplying the first reactant to the wafer 200. Further, in step C, the second film is formed on the first film, which is formed on the second surface, by performing a cycle a predetermined number of times (n₂ times, where n₂ is an integer of 1 or 2 or more), the cycle including step C1 of supplying the second precursor to the wafer 200 and step C2 of supplying the second reactant to the wafer 200. Further, in step F, the third film is formed on the second film on the first film, which is formed on the second surface, by performing a cycle a predetermined number of times (m times, where m is an integer of 1 or 2 or more), the cycle including step F1 of supplying the third precursor and the catalyst to the wafer 200 and step F2 of supplying the third reactant and the catalyst to the wafer 200.

In the present disclosure, for the sake of convenience, the above-described processing sequence may be denoted as follows. The same denotation may be used in modifications and other embodiments to be described later.

First modifying agent -> (First precursor -> First reactant) × n₁ -> (Second precursor → Second reactant) × n₂ -> Etching agent -> Second modifying agent -> (Third precursor + Catalyst -> Third reactant + Catalyst) × m

Further, as in the processing sequence shown below, step G of removing a native oxide film formed on the surface of the wafer 200 by supplying a cleaning agent to the wafer 200 may be further performed before performing step A. Further, as in the processing sequence shown below, step H of heat-treating the wafer 200 may be further performed after performing step F. Further, at least one selected from the group of step G and step H may be performed. Further, as will be described later, at least one selected from the group of step G and step H can be omitted. This point also applies to modifications and other embodiments to be described later.

Cleaning agent -> First modifying agent -> (First precursor -> First reactant) × n₁ → (Second precursor -> Second reactant) × n₂ → Etching agent -> Second modifying agent → (Third precursor + Catalyst -> Third reactant + Catalyst) × m -> Heat treatment

When the term "wafer" is used in the present disclosure, it may refer to "a wafer itself" or "a wafer and a stacked body of certain layers or films formed on a surface of the wafer." When the phrase "a surface of a wafer" is used in the present disclosure, it may refer to "a surface of a wafer itself" or "a surface of a certain layer formed on a wafer." When the expression "a certain layer is formed on a wafer" is used in the present disclosure, it may mean that "a certain layer is formed directly on a surface of a wafer itself" or that "a certain layer is formed on a layer formed on a wafer." When the term "substrate" is used in the present disclosure, it may be synonymous with the term "wafer."

The term "agent" used in the present disclosure includes at least one selected from the group of a gaseous substance and a liquefied substance. The liquefied substance includes a misty substance. That is, each of the first modifying agent, the first film-forming agent (the first precursor and the first reactant), the second film-forming agent (the second precursor and the second reactant), the second modifying agent, and the third film-forming agent (the third precursor, the third reactant, and the catalyst) may include a gaseous substance, a liquefied substance such as a misty substance, or both of them.

The term "layer" used in the present disclosure includes at least one selected from the group of a continuous layer and a discontinuous layer. For example, each of the first inhibitor layer and the second inhibitor layer may include a continuous layer, a discontinuous layer, or both of them as long as it is possible to cause a film-forming inhibitory action.

### (Wafer Charging and Boat Loading)

After the boat 217 is charged with a plurality of wafers 200 (wafer charging), the shutter 219s is moved by the shutter opener/closer 115s and the lower end opening of the manifold 209 is opened (shutter open). Thereafter, as shown in FIG. 1, the boat 217 charged with the plurality of wafers 200 is lifted up by the boat elevator 115 to be loaded into the process chamber 201 (boat loading). In this state, the seal cap 219 seals the lower end of the manifold 209 through the O-ring 220b. Thus, the wafers 200 are prepared inside the process chamber 201.

Each wafer 200 charged in the boat 217 has a first surface and a second surface, as shown in FIG. 4A. The first surface is the surface of the first base and the second surface is the surface of the second base. As described above, here, for example, a case where the first surface is a surface of a SiO film as the first base and the second surface is a surface of a SiN film as the second base will be described.

### (Pressure Adjustment and Temperature Adjustment)

After the boat loading is completed, the interior of the process chamber 201, that is, a space where the wafers 200 are placed, is vacuum-exhausted (decompression-exhausted) by the vacuum pump 246 to reach a desired pressure (degree of vacuum). At this time, the internal pressure of the process chamber 201 is measured by the pressure sensor 245, and the APC valve 244 is feedback-controlled based on the measured pressure information. Further, the wafers 200 in the process chamber 201 are heated by the heater 207 so as to have a desired temperature. At this time, the state of supplying electric power to the heater 207 is feedback-controlled based on the temperature information detected by the temperature sensor 263 so that the interior of the process chamber 201 has a desired temperature distribution. Further, the rotation of the wafers 200 by the rotator 267 is started. The exhaust of the interior of the process chamber 201 and the heating and rotation of the wafers 200 are continuously performed at least until the processing on the wafers 200 is completed.

### (Step G)

Thereafter, a cleaning agent is supplied to the wafer 200.

Specifically, the valve 243e is opened to allow the cleaning agent to flow into the gas supply pipe 232e. The flow rate of the cleaning agent is adjusted by the MFC 241e, and the cleaning agent is supplied into the process chamber 201 via the gas supply pipe 232b and the nozzle 249b and is exhausted from the exhaust port 231a. In this operation, the cleaning agent is supplied to the wafer 200 from the lateral side of the wafer 200 (cleaning agent supply). At this time, the valves 243f to 243h may be opened so as to supply an inert gas into the process chamber 201 via the nozzles 249a to 249c, respectively.

By supplying the cleaning agent to the wafer 200 under the process condition to be described later, a native oxide film formed on the second surface of the wafer 200 can be removed (etched) so that the second surface can be exposed. At this time, the first surface and the second surface of the wafer 200 are exposed as shown in FIG. 4A. When the first base is a SiO film and the second base is a SiN film, in a state where the first surface and the second surface are exposed, the first surface is OH-terminated over the entire region, and many regions of the second surface become a state that is not OH-terminated. That is, the first surface is terminated with OH groups over the entire region, and many regions of the second surface are not terminated with OH groups.

An example of a process condition for supplying the cleaning agent in step G is described as follows.
Processing temperature: room temperature (25 degrees C) to 200 degrees C, specifically 70 to 150 degrees C
Processing pressure: 10 to 2,000 Pa, specifically 100 to 1,500 Pa
Processing time: 1 to 60 minutes, specifically 10 to 60 minutes
Cleaning agent supply flow rate: 0.05 to 1 slm, specifically 0.1 to 0.5 slm
Inert gas supply flow rate (for each gas supply pipe): 1 to 10 slm, specifically 2 to 10 slm

In the present disclosure, the notation of a numerical range such as "25 to 200 degrees C" means that the lower limit value and the upper limit value are included in the range. Therefore, for example, "25 to 200 degrees C" means "25 degrees C or higher and 200 degrees C or lower." The same applies to other numerical ranges. In the present disclosure, the processing temperature means the temperature of the wafer 200 or the internal temperature of the process chamber 201, and the processing pressure means the internal pressure of the process chamber 201. Further, the processing time means the time during which a process is continued. Further, the gas supply flow rate of 0 slm means a case where no substance (gas) is supplied. These apply equally to the following descriptions.

After exposing the second surface by removing the native oxide film from the second surface, the valve 243e is closed to stop the supply of the cleaning agent into the process chamber 201. Then, the interior of the process chamber 201 is vacuum-exhausted to remove a gaseous substance and the like remaining in the process chamber 201 from the process chamber 201. At this time, the valves 243f to 243h are opened to allow an inert gas to be supplied into the process chamber 201 via the nozzles 249a to 249c. The inert gas supplied from the nozzles 249a to 249c acts as a purge gas, whereby the interior of the process chamber 201 is purged (purging).

An example of a process condition for purging in step G is described as follows.
Processing pressure: 1 to 30 Pa
Processing time: 1 to 120 seconds, specifically 1 to 60 seconds
Inert gas supply flow rate (for each gas supply pipe): 0.5 to 20 slm
It is desirable that the processing temperature for purging is the same as the processing temperature for supplying the cleaning agent.

As the cleaning agent, for example, a fluorine (F)-containing gas can be used. As the F-containing gas, for example, a chlorine trifluoride (ClF₃) gas, a chlorine fluoride (ClF) gas, a nitrogen fluoride (NF₃) gas, a hydrogen fluoride (HF) gas, a fluorine (F₂) gas, or the like can be used. Various cleaning liquids can also be used as the cleaning agent. For example, DHF cleaning can be performed using an HF aqueous solution as the cleaning agent. Further, for example, SC-1 cleaning (APM cleaning) can be performed using a cleaning liquid containing ammonia water, hydrogen peroxide water, and pure water as the cleaning agent. Further, for example, SC-2 cleaning (HPM cleaning) can be performed using a cleaning liquid containing hydrochloric acid, hydrogen peroxide water, and pure water as the cleaning agent. Further, for example, SPM cleaning can be performed using a cleaning liquid containing sulfuric acid and hydrogen peroxide water as the cleaning agent. That is, the cleaning agent may be a gaseous substance or a liquefied substance. Further, the cleaning agent may be a liquefied substance such as a misty substance. One or more of these gases and liquids can be used as the cleaning agent.

As the inert gas, a nitrogen (N₂) gas or a rare gas such as an argon (Ar) gas, a helium (He) gas, a neon (Ne) gas, a xenon (Xe) gas, or the like can be used. One or more of these gases can be used as the inert gas. This point also applies to each step to be described later.

It should be noted that step G can be omitted in case of using the wafer 200 in which the native oxide film formed on the surface of the wafer 200 is removed in advance and its state is maintained. In that case, step A to be described below is performed after the pressure adjustment and temperature adjustment.

### (Step A)

After performing step G, a first modifying agent, which reacts with the first surface, is supplied to the wafer 200.

Specifically, the valve 243a is opened to allow the first modifying agent to flow into the gas supply pipe 232a. The flow rate of the first modifying agent is adjusted by the MFC 241a, and the first modifying agent is supplied into the process chamber 201 via the nozzle 249a and is exhausted from the exhaust port 231a. In this operation, the first modifying agent is supplied to the wafer 200 from the lateral side of the wafer 200 (first modifying agent supply). At this time, the valves 243f to 243h may be opened to allow an inert gas to be supplied into the process chamber 201 via the nozzles 249a to 249c, respectively.

By supplying the first modifying agent, which reacts with the first surface, to the wafer 200 under the process condition to be described later, it is possible to form a first inhibitor layer on the first surface, as shown in FIG. 4B by chemisorbing first inhibitor molecules, which are at least a portion of the molecular structure of molecules constituting the first modifying agent, on the first surface of the wafer 200. That is, in this step, by supplying the first modifying agent, which reacts with the first surface, to the wafer 200, it is possible to form the first inhibitor layer on the first surface by adsorbing the first inhibitor molecules contained in the first modifying agent on the first surface. This makes it possible to terminate the first surface, which is the outermost surface of the first base, with the first inhibitor molecules that are at least a portion of the molecular structure of the molecules constituting the first modifying agent. The first inhibitor molecules are also referred to as film-forming inhibitory molecules (adsorption inhibitory molecules or reaction inhibitory molecules). In addition, the first inhibitor layer is also referred to as a film-forming inhibitory layer (adsorption inhibitory layer or a reaction inhibitory layer).

The first inhibitor layer formed in this step contains at least a portion of the molecular structure of the molecules constituting the first modifying agent, which are residues derived from the first modifying agent. The first inhibitor layer prevents a first precursor (first film-forming agent) from adsorption on the first surface, so that a progress of the film-forming reaction on the first surface in step B to be described later is inhibited (suppressed).

As at least the portion of the molecular structure of the molecules constituting the first modifying agent, that is, as the first inhibitor molecules, for example, a trialkylsilyl group such as a trimethylsilyl group (-SiMe₃) or a triethylsilyl group (-SiEt₃) can be exemplified. The trialkylsilyl group includes an alkyl group which is a kind of hydrocarbon group. In these cases, Si of the trimethylsilyl group or the triethylsilyl group is adsorbed on an adsorption site on the first surface of the wafer 200. When the first surface is a surface of a SiO film, the first surface includes an OH termination (OH group) as the adsorption site, and Si of the trimethylsilyl group or the triethylsilyl group is bonded to O of the OH termination (OH group) on the first surface, so that the first surface is terminated by an alkyl group such as a methyl group or an ethyl group. A hydrocarbon group typified by an alkyl group (alkylsilyl group) such as a methyl group (trimethylsilyl group) or an ethyl group (triethylsilyl group), which terminates the first surface, constitutes the first inhibitor layer which prevents the first precursor (first film-forming agent) from adsorption on the first surface, so that the progress of the film-forming reaction on the first surface in step B to be described later can be inhibited (suppressed).

When the first inhibitor molecule adsorbed on the adsorption site on the first surface is a trialkylsilyl group such as a trimethylsilyl group (-SiMe₃) or a triethylsilyl group (-SiEt₃), the first inhibitor molecule contains an alkyl group (alkylsilyl group) and the first inhibitor layer contain an alkyl group (alkylsilyl group) termination. In the case of an example in which the first inhibitor layer contains a hydrocarbon group termination such as an alkyl group (alkylsilyl group) termination, a high film-forming inhibition effect is obtained. The alkyl group (alkylsilyl group) termination and the hydrocarbon group termination are also referred to as an alkyl (alkylsilyl) termination and a hydrocarbon termination, respectively.

Further, in this step, at least the portion of the molecular structure of the molecules constituting the first modifying agent may be adsorbed on a portion of the second surface of the wafer 200, but the adsorption amount thereof is very small and the amount of adsorption on the first surface of the wafer 200 is overwhelmingly large. Such selective (preferential) adsorption is possible because the process condition in this step is a condition that the first modifying agent does not undergo gas phase decomposition in the process chamber 201. This is also possible because the first surface is OH-terminated over the entire region, whereas many regions on the second surface are not OH-terminated. In this step, since the first modifying agent does not undergo the gas phase decomposition in the process chamber 201, at least a portion of the molecular structure of the molecules constituting the first modifying agent is not multiple-deposited on the first surface and the second surface, and at least a portion of the molecular structure of the molecules constituting the first modifying agent is selectively adsorbed on the first surface among the first surface and the second surface, whereby the first surface is selectively terminated by at least the portion of the molecular structure of the molecules constituting the first modifying agent.

An example of a process condition for supplying the first modifying agent in step A is described as follows.
Processing temperature: room temperature (25 degrees C) to 500 degrees C, specifically room temperature to 250 degrees C
Processing pressure: 5 to 2,000 Pa, specifically 10 to 1,000 Pa
Processing time: 1 second to 120 minutes, specifically 30 seconds to 60 minutes
First modifying agent supply flow rate: 0.001 to 3 slm, specifically 0.001 to 0.5 slm
Inert gas supply flow rate (for each gas supply pipe): 0 to 20 slm

After selectively forming the first inhibitor layer on the first surface of the wafer 200, the valve 243a is closed to stop the supply of the first modifying agent into the process chamber 201. Then, a gaseous substance and the like remaining in the process chamber 201 are removed from the process chamber 201 (purging) according to the same processing procedure and process condition as in the purging in step G. It is desirable that the processing temperature for purging is the same as the processing temperature for supplying the first modifying agent.

As the first modifying agent, for example, an (aminosilane-based) compound having a structure in which an amino group is directly bonded to silicon (Si) or a compound having a structure in which an amino group and an alkyl group are directly bonded to silicon (Si) can be used.

Examples of the first modifying agent may include (dimethylamino)silane ((CH₃)₂NSiH₃), (diethylamino)silane ((C₂H₅)₂NSiH₃), (dipropylamino)silane ((C₃H₇)₂NSiH₃), (dibutylamino)silane ((C₄H₉)₂NSiH₃), (dimethylamino)trimethylsilane ((CH₃)₂NSi(CH₃)₃), (diethylamino)triethylsilane ((C₂H₅)₂NSi(C₂H₅)₃), (dimethylamino)triethylsilane ((CH₃)₂NSi(C₂H₅)₃), (diethylamino)trimethylsilane ((C₂H₅)₂NSi(CH₃)₃), (dipropylamino)trimethylsilane ((C₃H₇)₂NSi(CH₃)₃), (dibutylamino)trimethylsilane ((C₄H₉)₂NSi(CH₃)₃), (trimethylsilyl)amine ((CH₃)₃SiNH₂), (triethylsilyl)amine ((C₂H₅)₃SiNH₂), and the like. One or more of these can be used as the modifying agent. Further, examples of the modifying agents may include bis(dimethylamino)dimethylsilane ([(CH₃)₂N]₂Si(CH₃)₂), bis(diethylamino)diethylsilane ([(C₂H₅)₂N]₂Si(C₂H₅)₂), bis(dimethylamino)diethylsilane ([(CH₃)₂N]₂Si(C₂H₅)₂), bis(diethylamino)dimethylsilane ([(C₂H₅)₂N]₂Si(CH₃)₂), bis(dimethylamino)silane ([(CH₃)₂N]₂SiH₂), bis(diethylamino)silane ([(C₂H₅)₂N]₂SiH₂), bis(dimethylaminodimethylsilyl)ethane ([(CH₃)₂N(CH₃)₂Si]₂C₂H₆), bis(dipropylamino)silane ([(C₃H₇)₂N]₂SiH₂), bis(dibutylamino)silane ([(C₄H₉)₂N]₂SiH₂), bis(dipropylamino)dimethylsilane ([(C₃H₇)₂N]₂Si(CH₃)₂), bis(dipropylamino)diethylsilane ((C₃H₇)₂N]₂Si(C₂H₅)₂), (dimethylsilyl)diamine ((CH₃)₂Si(NH₂)₂), (diethylsilyl)diamine ((C₂H₅)₂Si(NH₂)₂), (dipropylsilyl)diamine ((C₃H₇)₂Si(NH₂)₂), bis(dimethylaminodimethylsilyl)methane ([(CH₃)₂N(CH₃)₂Si]₂CH₂), bis(dimethylamino)tetramethyldisilane ([(CH₃)₂N]₂(CH₃)₄Si₂), and the like. One or more of these can be used as the first modifying agent.

### (Step B)

After performing step A, a first film-forming agent, in which a first energy is imparted to at least a portion of the first film-forming agent, is supplied to the wafer 200. That is, the first film-forming agent, in which the first energy is imparted to the at least a portion of the first film-forming agent, is supplied to the wafer 200 so as to react with the second surface. As a result, a first film is selectively (preferentially) formed on the second surface. Specifically, in this step, the following step B1 and step B2 are sequentially executed.

Further, in the following example, a first precursor and a first reactant are each supplied at a first temperature. That is, in the following example, each of the first precursor and the first reactant is heated at the first temperature, thereby imparting the first energy to each of the first precursor and the first reactant. In this case, at least one selected from the group of the first precursor and the first reactant may be excited (thermally excited) by the first energy. In the following example, the first temperature is set to a temperature lower than a second temperature to be described later. Further, in the following example, the first temperature is set to be equal to or higher than the processing temperature in step A, desirably higher than the processing temperature in step A. Therefore, in step B1 and step B2, the output of the heater 207 is adjusted so as to keep a processing temperature (the first temperature) equal to or higher than the processing temperature in step A, and desirably keep the first temperature higher than the processing temperature in step A.

### [Step B1]

In this step, a first precursor (first precursor gas) as a first film-forming agent is supplied to the wafer 200 after performing step A, that is, the wafer 200 with the first inhibitor layer selectively formed on the first surface, at the first temperature.

Specifically, the valve 243b is opened to allow the first precursor to flow into the gas supply pipe 232b. The flow rate of the first precursor is adjusted by the MFC 241b, and the first precursor is supplied into the process chamber 201 via the nozzle 249b and is exhausted from the exhaust port 231a. In this operation, the first precursor is supplied to the wafer 200 from the lateral side of the wafer 200 (first precursor supply). At this time, the valves 243f to 243h may be opened to allow an inert gas to be supplied into the process chamber 201 via the nozzles 249a to 249c, respectively.

By supplying the first precursor to the wafer 200 under the process condition to be described later, it is possible to selectively chemisorb at least a portion of the molecular structure of molecules constituting the first precursor on the second surface while suppressing at least a portion of the molecular structure of molecules constituting the first precursor from chemisorption on the first surface. Thereby, a first layer is selectively formed on the second surface. The first layer contains at least a portion of the molecular structure of the molecules constituting the first precursor, which is residues of the first precursor. That is, the first layer contains at least some of atoms constituting the first precursor.

In this step, it is possible to allow the formation of the first layer to proceed under a low temperature condition as will be described later, that is, at the first temperature. By forming the first layer at the first temperature in this way, it is possible to suppress invalidation and/or removal (desorption) of the first inhibitor layer formed on the first surface. The invalidation of the first inhibitor layer means that the molecular structure of the molecules constituting the first inhibitor layer, the arrangement structure of atoms constituting the first inhibitor layer, and the like are changed so as to enable the adsorption of the film-forming agent on the first surface or the reaction between the first surface and the film-forming agent.

Further, by forming the first layer under the low temperature condition as will be described later, that is, at the first temperature, the first precursor can be prevented from being thermally decomposed (gas phase-decomposed), that is, autolyzed, in the process chamber 201. As a result, it is possible to prevent multiple deposition of at least a portion of the molecular structure of molecules constituting the first precursor on the first surface and the second surface and selectively adsorb at least a portion of the molecular structure of molecules constituting the first precursor on the second surface among the first surface and the second surface.

Further, in this step, at least a portion of the molecular structure of the molecules constituting the first precursor may be adsorbed on a portion of the first surface of the wafer 200, but the adsorption amount thereof is very small and the amount of adsorption on the second surface of the wafer 200 is overwhelmingly large. Such selective (preferential) adsorption is possible because the process condition in this step is the low temperature condition, as will be described later, that is, the first temperature, and the condition that the first precursor does not undergo vapor phase decomposition in the process chamber 201. Further, this is also possible because the first inhibitor layer is formed over the entire region of the first surface, whereas the first inhibitor layer is not formed in many regions of the second surface.

An example of the process condition for supplying the first precursor in step B1 is described as follows.
Processing temperature (first temperature): 350 to 600 degrees C, specifically 400 to 550 degrees C
Processing pressure: 1 to 2,000 Pa, specifically 10 to 1,333 Pa
Processing time: 1 to 180 seconds, specifically 10 to 120 seconds
First precursor supply flow rate: 0.001 to 2 slm, specifically 0.01 to 1 slm
Inert gas supply flow rate (for each gas supply pipe): 0 to 20 slm

After selectively forming the first layer on the second surface of the wafer 200, the valve 243b is closed to stop the supply of the first precursor into the process chamber 201. Then, a gaseous substance and the like remaining in the process chamber 201 are removed from the process chamber 201 (purging) according to the same processing procedure and process condition as in the purging in step G. It is desirable that the processing temperature for purging is the same as the processing temperature for supplying the first precursor.

As the first precursor, for example, when forming the first film containing atoms X in step B, a gas (substance) containing one or more atoms X in one molecule can be used.

Further, a gas (substance) containing no chemical bond between atoms X can be used as the first precursor. The atoms X may include Si, germanium (Ge), titanium (Ti), tantalum (Ta), tungsten (W), aluminum (Al), and the like. As the first precursor, it is desirable to use, for example, a Si-containing gas (Si-containing substance) containing one or more Si in one molecule, and it is more desirable to use a Si-containing gas (Si-containing substance) containing one Si in one molecule. Further, as the first precursor, it is desirable to use, for example, a Si-containing gas (Si-containing substance) that does not contain a chemical bond between Si, that is, does not contain a Si-Si bond.

As the first precursor, for example, a Si- and halogen-containing gas (Si- and halogen-containing substance) can be used. The halogen may include chlorine (Cl), fluorine (F), bromine (Br), iodine (I), and the like. It is desirable that the Si- and halogen-containing gas contains halogen in the form of a chemical bond between Si and halogen. As the Si- and halogen-containing gas, for example, a silane-based gas having a Si-Cl bond, a Si-F bond, a Si-Br bond, or a Si-I bond, that is, a chlorosilane-based gas, a fluorosilane-based gas, a bromosilane-based gas, or an iodosilane-based gas, can be used. The Si- and halogen-containing gas may further contain carbon (C) and in such a case, it is desirable that C is contained in the form of a Si-C bond. As the Si- and halogen-containing gas, for example, a silane-based gas containing Si, Cl, and an alkylene group and having a Si-C bond, that is, an alkylenechlorosilane-based gas, can be used. The alkylene group may include a methylene group, an ethylene group, a propylene group, a butylene group, and the like. Further, as the Si- and halogen-containing gas, for example, a silane-based gas containing Si, Cl, and an alkyl group and having a Si-C bond, that is, an alkylchlorosilane-based gas, can be used. The alkyl group may include a methyl group, an ethyl group, a propyl group, a butyl group, and the like. The Si- and halogen-containing gas may further contain O and, in such a case, it is desirable that O is contained in the form of a Si-O bond, for example in the form of a siloxane bond (Si-O-Si bond). As the Si- and halogen-containing gas, for example, a silane-based gas having Si, Cl, and a siloxane bond, that is, a chlorosiloxane-based gas, can be used.

Examples of the first precursor may include 1,1,3,3-tetrachloro-1,3-disilacyclobutane (C₂H₄Cl₄Si₂), 1,1,2,2-tetrachloro-1,2-dimethyldisilane ((CH₃)₂Si₂Cl₄), 1,2-dichloro-1,1,2,2-tetramethyldisilane ((CH₃)₄Si₂Cl₂), bis(trichlorosilyl)methane ((SiCl₃)₂CH₂), 1,2-bis(trichlorosilyl)ethane ((SiCl₃)₂C₂H₄), and the like. Further, examples of the first precursor may include monochlorosilane (SiH₃Cl), dichlorosilane (SiH₂Cl₂), trichlorosilane (SiHCl₃), tetrachlorosilane (SiCl₄), hexachlorodisilane (Si₂Cl₆), octachlorotrisilane (Si₃Cl₈), and the like. Further, examples of the first precursor may include hexachlorodisiloxane (Cl₃Si-O-SiCl₃), octachlorotrisiloxane (Cl₃Si-O-SiCl₂-O-SiCl₃), and the like. Further, examples of the first precursor may include tetrafluorosilane (SiF₄), difluorosilane (SiH₂F₂), tetrabromosilane (SiBr₄), dibromosilane (SiH₂Br₂), tetraiodosilane (SiI₄), diiodosilane (SiH₂I₂), and the like. One or more of these can be used as the first precursor.

### [Step B2]

After step B1 is completed, a first reactant (first reaction gas) as a first film-forming agent is supplied to the wafer 200, that is, the wafer 200 with the first layer selectively formed on the second surface, at the first temperature. Here, an example of using a nitrogen (N)-containing gas (N-containing substance) as the first reactant (first reaction gas) will be described.

Specifically, the valve 243c is opened to allow the first reactant to flow into the gas supply pipe 232c. The flow rate of the first reactant is adjusted by the MFC 241c, and the first reactant is supplied into the process chamber 201 via the nozzle 249c and is exhausted from the exhaust port 231a. In this operation, the first reactant is supplied to the wafer 200 from the lateral side of the wafer 200 (first reactant supply). At this time, the valves 243f to 243h may be opened to allow an inert gas to be supplied into the process chamber 201 via the nozzles 249a to 249c, respectively.

By supplying the first reactant to the wafer 200 under the process condition to be described later, it is possible to nitride at least a portion of the first layer formed on the second surface of the wafer 200 in step B1. As a result, a second layer formed by nitriding the first layer is formed on the second surface.

In this step, it is possible to progress the formation of the second layer under a low temperature condition as will be described later, that is, at the first temperature. In this way, by forming the second layer under the low temperature condition as will be described later, that is, at the first temperature, it is possible to suppress invalidation and/or removal (desorption) of the first inhibitor layer formed on the first surface.

An example of the process condition for supplying the first reactant in step B2 is described as follows.
Processing temperature (first temperature): 350 to 600 degrees C, specifically 400 to 550 degrees C
Processing pressure: 1 to 4,000 Pa, specifically 1 to 1,333 Pa
Processing time: 1 to 120 seconds, specifically 5 to 80 seconds
First reactant supply flow rate: 0.01 to 10 slm
Inert gas supply flow rate (for each gas supply pipe): 0 to 20 slm

After changing (modifying) the first layer into the second layer by nitriding the first layer formed on the second surface of the wafer 200, the valve 243c is closed to stop the supply of the first reactant into the process chamber 201. Then, a gaseous substance and the like remaining in the process chamber 201 are removed from the process chamber 201 (purging) according to the same processing procedure and process conditions as in the purging in step G. It is desirable that the processing temperature for purging is the same as the processing temperature for supplying the first reactant.

As the first reactant, for example, a N-containing gas (N-containing substance) can be used. As the N-containing gas (N-containing substance), for example, a N- and hydrogen (H)-containing gas and a C- and N-containing gas can be used. As the N- and H-containing gas, for example, a hydrogen nitride-based gas containing a N-H bond can be used. As the C- and N-containing gas, an amine-based gas and an organic hydrazine-based gas can be used.

Examples of the first reactant may include ammonia (NH₃), hydrazine (N₂H₄), diazene (N₂H₂), N₃H₈, and the like. Further, examples of the first reactant may include monoethylamine (C₂H₅NH₂), diethylamine ((C₂H₅)₂NH), triethylamine ((C₂H₅)₃N), monomethylamine (CH₃NH₂), dimethylamine ((CH₃)₂NH), trimethylamine ((CH₃)₃N), and the like. Further, examples of the first reactant may include monomethylhydrazine ((CH₃)HN₂H₂), dimethylhydrazine ((CH₃)₂N₂H₂), trimethylhydrazine ((CH₃)₂N₂(CH₃)H), and the like. One or more of these can be used as the first reactant.

### [Performing Predetermined Number of Times]

By performing a cycle a predetermined number of times (n₁ times, where n₁ is an integer of 1 or 2 or more), the cycle including non-simultaneously, that is, alternately non-synchronously, performing the above-described step B1 and step B2, it is possible to selectively (preferentially) form a first film on the second surface among the first surface and the second surface of the wafer 200, as shown in FIG. 4C. For example, when the above-described first precursor and first reactant are used, it is possible to allow a SiN film or a silicon carbonitride film (SiCN film) as the first film to selectively grow on the second surface. It is desirable that the above cycle is repeated a plurality of times. That is, the thickness of the second layer formed per cycle may be set to be smaller than a desired film thickness of the first film, and the above cycle may be repeated a plurality of times until the thickness of the first film formed by stacking second layers reaches the desired film thickness.

As described above, by performing the above cycle a predetermined number of times, it is possible to allow the first film to selectively grow on the second surface of the wafer 200. At this time, since the first inhibitor layer is formed on the first surface of the wafer 200, it is possible to suppress the growth of the first film on the first surface. That is, by performing the above cycle a predetermined number of times, it is possible to promote the growth of the first film on the second surface while suppressing the growth of the first film on the first surface.

Further, as described above, when step B1 and step B2 are performed, since the first inhibitor layer formed on the first surface is maintained on the first surface as described above, it is possible to suppress the growth of the first film on the first surface. However, when the formation of the first inhibitor layer on the first surface is insufficient due to some factors, the formation and growth of the first film on the first surface may occur very slightly. However, even in this case, the thickness of the first film formed on the first surface is much thinner than the thickness of the first film formed on the second surface. As used herein, "selectively (preferentially) forming the first film on the second surface" means to include not only a case where the first film is formed only on the second surface with no first film formed on the first surface, but also a case where a very thin first film is formed on the first surface and a first film much thicker than the first film formed on the first surface is formed on the second surface.

Further, in step B in which step B1 and step B2 are performed, it is desirable to control the process condition so that the reactivity between the first film-forming agent (the first precursor and the first reactant) and the first inhibitor layer in step B is lower than the reactivity between the second film-forming agent (the second precursor and the second reactant) and the first inhibitor layer in step C. This makes it possible to suppress invalidation and/or removal (desorption) of the first inhibitor layer when forming the first film, thereby forming the first film on the second surface with high selectivity.

### (Step C)

After performing step B, a second film-forming agent, in which a second energy is imparted to at least a portion of the second film-forming agent, is supplied to the wafer 200. That is, the second film-forming agent, in which the second energy higher than the first energy is imparted to at least a portion of the second film-forming agent, is supplied to the wafer 200 so as to react with the first film formed on the second surface. As a result, a second film is selectively (preferentially) formed on the first film, which is formed on the second surface of the wafer 200. In this step, specifically, the following step C1 and step C2 are sequentially executed.

Further, in the following example, a second precursor and a second reactant as the second film-forming agent are each supplied at a second temperature higher than the first temperature. That is, in the following example, each of the second precursor and the second reactant is heated at the second temperature higher than the first temperature, thereby imparting the second energy to each of the second precursor and the second reactant. In this case, at least one selected from the group of the second precursor and the second reactant may be excited (thermally excited) by the second energy. Therefore, in step C1 and step C2, the output of the heater 207 is adjusted so as to keep a processing temperature (the second temperature) higher than the processing temperature (the first temperature) in step B1 and step B2.

### [Step C1]

In this step, a second precursor (second precursor gas) as a second film-forming agent is supplied to the wafer 200 after performing step B, that is, the wafer 200 with the first film selectively formed on the second surface, at the second temperature. Here, an example in which a precursor having a molecular structure different from that of the first precursor is used as the second precursor will be described.

Specifically, the valve 243d is opened to allow the second precursor to flow into the gas supply pipe 232d. The flow rate of the second precursor is adjusted by the MFC 241d, and the second precursor is supplied into the process chamber 201 via the nozzle 249a and is exhausted from the exhaust port 231a. In this operation, the second precursor is supplied to the wafer 200 from the lateral side of the wafer 200 (second precursor supply). At this time, the valves 243f to 243h may be opened to allow an inert gas to be supplied into the process chamber 201 via the nozzles 249a to 249c, respectively.

By supplying the second precursor to the wafer 200 under the process condition to be described later, it is possible to selectively chemisorb at least a portion of the molecular structure of molecules constituting the second precursor on the first film formed on the second surface. As a result, a third layer is selectively formed on the first film formed on the second surface. The third layer contains at least a portion of the molecular structure of the molecules constituting the second precursor, which is residues of the second precursor. That is, the third layer contains at least some of atoms constituting the second precursor.

In this step, the formation of the third layer can proceed under a relatively high temperature condition as will be described later, that is, at the second temperature. By forming the third layer at the second temperature in this way, it is possible to efficiently thermally decompose (vapor phase-decompose) the second precursor, thereby forming the third layer with few impurities and high density.

Further, by forming the third layer under the relatively high temperature condition as will be described later, that is, at the second temperature, it is possible to invalidate and/or remove (desorb) at least a portion of the first inhibitor layer remaining on the first surface. Therefore, in this step, at least a portion of the molecular structure of molecules constituting the second precursor may be adsorbed on a portion of the first surface of the wafer 200. However, even in that case, the adsorption amount thereof is very small and the amount of adsorption on the first film formed on the second surface of the wafer 200 is overwhelmingly large. This is because at the second temperature, the invalidation and/or removal of at least a portion of the first inhibitor layer does not proceed abruptly, but rather slowly and gradually.

An example of the process condition for supplying the second precursor in step C1 is described as follows.
Processing temperature (second temperature): 450 to 800 degrees C, specifically 600 to 700 degrees C
Processing pressure: 1 to 2,000 Pa, specifically 10 to 1,333 Pa
Processing time: 1 to 180 seconds, specifically 10 to 120 seconds
Second precursor supply flow rate: 0.001 to 2 slm, specifically 0.01 to 1 slm
Inert gas supply flow rate (for each gas supply pipe): 0 to 20 slm

After selectively forming the third layer on the first film formed on the second surface of the wafer 200, the valve 243d is closed to stop the supply of the second precursor into the process chamber 201. Then, a gaseous substance and the like remaining in the process chamber 201 are removed from the process chamber 201 (purging) according to the same processing procedure and process conditions as the purging in step G. It is desirable that the processing temperature for purging is the same as the processing temperature for supplying the second precursor.

As the second precursor, for example, a compound having a different molecular structure from that of the first precursor can be used. It is desirable that the thermal decomposition temperature of the second precursor is lower than the thermal decomposition temperature of the first precursor. Further, under the same condition, it is desirable that the reactivity of the second precursor is higher than the reactivity of the first precursor. Moreover, as the second precursor, it is desirable to use a precursor having higher reactivity with the first inhibitor layer formed in the above-described step A than the first precursor. By using such a second precursor, it is possible to efficiently form the third layer with high density.

Further, as the second precursor, for example, when forming the second film containing atoms X in step C, a gas (substance) containing one or more atoms X in one molecule can be used. Further, a gas (substance) containing a chemical bond between atoms X can be used as the second precursor. The atoms X are the same as the atoms X in the above-described first precursor. As the second precursor, it is desirable to use, for example, a Si-containing gas (Si-containing substance) containing one or more Si in one molecule, and it is more desirable to use a Si-containing gas (Si-containing substance) containing two or more Si in one molecule. Further, as the second precursor, it is desirable to use, for example, a Si-containing gas (Si-containing substance) that contains a chemical bond between Si, that is, a Si-Si bond.

As the second precursor, for example, the same Si- and halogen-containing gas (Si- and halogen-containing substance) as the various first precursors exemplified in the above-described step B1 can be used. However, as the second precursor, it is desirable to select a Si- and halogen-containing gas (Si- and halogen-containing substance) having a molecular structure different from that of the first precursor.

Further, examples of the second precursor may include aminosilane-based gases, which are compounds having a structure in which an amino group is directly bonded to Si, such as tetrakis(dimethylamino)silane (Si[N(CH₃)₂]₄), tris(dimethylamino)silane (Si[N(CH₃)₂]₃H), bis(diethylamino)silane (Si[N(C₂H₅)₂]₂H₂), bis(tert-butylamino)silane (SiH₂[NH(C₄H₉)]₂), (diisobutylamino)silane (SiH₃[N(C₄H₉)₂]), and (diisopropylamino)silane (SiH₃[N(C₃H₇)₂]). One or more of these gases can be used as the second precursor.

### [Step C2]

After step C1 is completed, a second reactant (second reaction gas) as the second film-forming agent is supplied to the wafer 200, that is, the wafer 200 with the third layer selectively formed on the first film formed on the second surface, at the second temperature. Here, an example of using a N-containing gas (N-containing substance) as the second reactant will be described. This step can be performed according to the same processing procedure as the above-described step B2 under the following process condition. This step makes it possible to nitride at least a portion of the third layer formed on the first film in step C1. As a result, a fourth layer formed by nitriding the third layer is formed on the first film formed on the second surface.

In this step, the formation of the fourth layer can proceed under a relatively high temperature condition as will be described later, that is, at the second temperature. By nitriding the third layer at the second temperature in this way, impurities can be removed and defects can be repaired, which makes it possible to change the third layer to the fourth layer with fewer impurities and defects and higher density. In addition, in this step, since the formation of the fourth layer proceeds under the relatively high temperature condition as will be described later, that is, at the second temperature, it is possible to invalidate and/or remove at least a portion of the first inhibitor layer remaining on the first surface. However, as in step C1, also in this step, at the second temperature, the invalidation and/or removal of at least a portion of the first inhibitor layer does not proceed abruptly, but rather slowly and gradually.

An example of the process condition for supplying the second reactant in step C2 is described as follows.
Processing temperature (second temperature): 450 to 800 degrees C, specifically 600 to 700 degrees C
Processing pressure: 1 to 4,000 Pa, specifically 1 to 1,333 Pa
Processing time: 1 to 120 seconds, specifically 5 to 80 seconds
Second reactant supply flow rate: 0.01 to 10 slm
Inert gas supply flow rate (for each gas supply pipe): 0 to 20 slm

After changing (modifying) the third layer to the fourth layer by nitriding the third layer formed on the first film formed on the second surface of the wafer 200, a gas and the like remaining in the process chamber 201 are removed from the process chamber 201 (purging) according to the same processing procedure as the purging in step G. It is desirable that the processing temperature for purging is the same as the processing temperature for supplying the second reactant.

As the second reactant, for example, the same N-containing gas (N-containing substance) as the various first reactants exemplified in the above-described step B2 can be used. The first reactant and the second reactant may have different or same molecular structures. When the molecular structures of the first reactant and the second reactant are the same, it is possible to reduce the kinds of substances used. As a result, it is possible to simplify the processing sequence, thereby simplifying a supply system in the substrate processing apparatus and reducing the apparatus cost.

### [Performing Predetermined Number of Times]

By performing a cycle a predetermined number of times (n₂ times, where n₂ is an integer of 1 or 2 or more), the cycle including non-simultaneously, that is, alternately non-synchronously, performing the above-described step C1 and step C2, a second film can be selectively formed on the first film formed on the second surface of the wafer 200, as shown in FIG. 4D. For example, when the above-described second precursor and second reactant are used, it is possible to allow a SiN film or a SiCN film as the second film to selectively grow on the first film. Further, the second film is provided so as to cover the entire surface of the first film, as shown in FIG. 4D. That is, by forming the second film on the first film, the upper surface of the first film is not exposed. It is desirable that the above cycle is repeated a plurality of times. That is, the thickness of the fourth layer formed per cycle may be set to be smaller than a desired film thickness of the second film, and the above cycle may be repeated a plurality of times until the thickness of the second film formed by stacking fourth layers reaches the desired film thickness.

As described above, by performing the above cycle a predetermined number of times, the first inhibitor layer formed on the first surface of the wafer 200 may be invalidated and/or removed in parallel to the formation of the second film on the first film formed on the second surface of the wafer 200. In this case, a second film thinner than the second film formed on the first film may be locally formed on the first surface by selective rupture, as shown in FIG. 4D. The second film formed on the first surface by selective rupture is removed (etched) from the first surface in step D to be described later. Although FIG. 4D shows an example in which the second film is locally formed on the first surface, a second film thinner than the second film formed on the first film may be formed over the entire first surface, and a first film may be locally formed on the first surface.

The second film formed on the first film in step C has high film density because impurities are removed and defects are also repaired during the formation process. Therefore, the oxidation resistance of the second film is higher than that of the first film. By forming such a second film having high oxidation resistance on the first film, the second film serves as an oxidation blocking layer (oxidation barrier layer), thereby increasing the oxidation resistance of a stacked film (stacked body) of the first film and the second film, which is formed on the second surface. As a result, it is possible to suppress oxidation of the stacked film due to exposure to the atmosphere or the like, and it is also possible to suppress deterioration in processing resistance (etching resistance) due to the oxidation of the stacked film. That is, the stacked film can maintain high etching resistance. As a result, when etching a film (including at least one selected from the group of the first film and the second film) formed on the first surface by selective rupture in step D to be described later, it is possible to suppress film reduction on the second surface due to etching of the stacked film. Further, since the stacked film has high oxidation resistance and is hard to be oxidized, it is possible to leave many regions of the surface thereof in a non-OH-terminated state. That is, the stacked film can maintain a state in which the second inhibitor layer is hard to form on the surface of the stacked film. As a result, after etching the film formed on the first surface by selective rupture in step D, when performing step E, an inhibitor layer can be selectively formed on the first surface among the first surface and the surface of the stacked film.

Further, since the first film is also heated at the second temperature when performing step C, some of the impurities contained in the first film may be removed and some of the defects may be repaired, thereby increasing the film density of the first film. That is, in step C, by forming the second film on the first film, the oxidation resistance of the first film may become higher than the oxidation resistance of the first film before forming the second film. This may contribute to improving the oxidation resistance of the stacked film of the first film and the second film. However, even in that case, the second film has a lower impurity concentration, higher film density, and higher oxidation resistance than the first film.

The relationship between the thickness of the second film formed in step C and the thickness of the first film formed in step B is not particularly limited. That is, the thickness of the second film formed in step C may be thicker than the thickness of the first film, may be equal to the thickness of the first film, or may be thinner than the thickness of the first film.

### (Step D)

After performing step C, an etching agent is supplied to the wafer 200. This step can be performed according to the same processing procedure as in the above-described step G under the following process condition by using the etching agent. By supplying the etching agent to the wafer 200 under the process condition to be described later, the film including at least one selected from the group of the first film and the second film, which is formed on the first surface, is removed (etched) by selective rupture, so that it is possible to expose the first surface. As a result, the first surface of the wafer 200 is exposed as shown in FIG. 4E.

In this step, when the film including at least one selected from the group of the first film and the second film, which is formed on the first surface, is removed by etching, the second film formed on the first film may be also removed. However, even in that case, the etching amount thereof is very small, and most of the second film formed on the first film may be left. This is because the second film formed on the first film is more stable and much thicker than the second film formed on the first surface.

An example of the process condition for supplying the etching agent in step D is described as follows.
Processing temperature: room temperature (25 degrees C) to 550 degrees C, specifically room temperature to 450 degrees C
Processing pressure: 1 to 2,000 Pa, specifically 1 to 1,000 Pa
Processing time: 10 seconds to 60 minutes, specifically 1 to 60 minutes
Etching agent supply flow rate: 0.001 to 2 slm, specifically 0.001 to 0.5 slm
Inert gas supply flow rate (for each gas supply pipe): 0 to 10 slm, specifically 1 to 10 slm

After exposing the first surface by removing the film including at least one selected from the group of the first film and the second film, which is formed on the first surface, from the first surface, the valve 243e is closed to stop the supply of the etching agent into the process chamber 201. Then, a gaseous substance and the like remaining in the process chamber 201 are removed from the process chamber 201 (purging) according to the same processing procedure and process conditions as the purging in step G. It is desirable that the processing temperature for purging is the same as the processing temperature for supplying the etching agent.

As the etchant, for example, the same F-containing gas as the various cleaning agents exemplified in the above-described step G and various cleaning liquids can be used.

### (Step E)

After performing step D, a second modifying agent, which reacts with the first surface, is supplied to the wafer 200. This step can be performed according to the same processing procedure and process condition as in the above-described step A except that the second modifying agent is used. By supplying the second modifying agent, which reacts with the first surface, to the wafer 200 under the same process condition as in the above-described step A, second inhibitor molecules, which are at least a portion of the molecular structure of molecules constituting the second modifying agent, are allowed to be chemisorbed on the first surface of the wafer 200, so that it is possible to form a second inhibitor layer on the first surface, as shown in FIG. 4F. That is, in this step, by supplying the second modifying agent, which reacts with the first surface, to the wafer 200, the second inhibitor molecules contained in the second modifying agent are allowed to be adsorbed on the first surface, so that it is possible to form the second inhibitor layer on the first surface. This makes it possible to terminate the first surface, which is the outermost surface of the first base, with the second inhibitor molecules that are at least a portion of the molecular structure of the molecules constituting the second modifying agent.

The second inhibitor layer formed in this step contains at least a portion of the molecular structure of the molecules constituting the second modifying agent, which are residues derived from the second modifying agent. The second inhibitor layer prevents a third precursor (third film-forming agent) from adsorption on the first surface so that a progress of the film-forming reaction on the first surface in step F to be described later is inhibited (suppressed). The reason that the second inhibitor layer can prevent the third precursor (third film-forming agent) from adsorption on the first surface so as to inhibit (suppress) the progress of the film-forming reaction on the first surface is the same as the reason as in the above-described step A.

In this step, at least a portion of the molecular structure of the molecules constituting the second modifying agent may be adsorbed on a portion of the second film, but the adsorption amount thereof is very small, and the adsorption amount on the first surface of the wafer 200 is overwhelmingly large. Such selective (preferential) adsorption is possible because the first surface is OH-terminated over the entire region, as described above, whereas many regions on the surface of the second film are not OH-terminated.

After selectively forming the second inhibitor layer on the first surface of the wafer 200, the valve 243a is closed to stop the supply of the second modifying agent into the process chamber 201. Then, a gaseous substance and the like remaining in the process chamber 201 are removed from the process chamber 201 (purging) according to the same processing procedure and process conditions as the purging in step G. It is desirable that the processing temperature for purging is the same as the processing temperature for supplying the second modifying agent.

As the second modifying agent, for example, similar to the various first modifying agents exemplified in the above-described step A, a compound having a structure in which an amino group is directly bonded to Si or a compound having a structure in which an amino group and an alkyl group are directly bonded to Si can be used.

### (Step F)

After performing step E, a third film-forming agent, in which a third energy is imparted to at least a portion of the third film-forming agent, is supplied to the wafer 200. That is, the third film-forming agent, in which a third energy lower than the second energy is imparted to at least a portion of the third film-forming agent, is supplied to the wafer 200 so as to react with the second film on the first film formed on the second surface. As a result, a third film is selectively (preferentially) formed on the second film on the first film formed on the second surface of the wafer 200. In this step, specifically, the following step F1 and step F2 are sequentially executed.

Further, in the following example, a third precursor, a third reactant, and a catalyst as the third film-forming agent are each supplied at a third temperature lower than the second temperature. That is, in the following example, each of the third precursor, the third reactant, and the catalyst is heated at the third temperature lower than the second temperature, thereby imparting the third energy to each of the third precursor, the third reactant, and the catalyst. In this case, at least one selected from the group of the third precursor, the third reactant, and the catalyst may be excited (thermally excited) by the third energy. Therefore, in step F1 and step F2, the output of the heater 207 is adjusted so as to keep a processing temperature (the third temperature) lower than the processing temperature (the second temperature) in step C1 and step C2.

Further, in this step, the supply of the catalyst may be omitted depending on the process condition. Specifically, the supply of the catalyst may be omitted in step F1, the supply of the catalyst may be omitted in step F2, or the supply of the catalyst may be omitted in each of step F1 and step F2. In this way, in this step, the third precursor and the third reactant may be used as the third film-forming agent.

### [Step F1]

In step F1, a third precursor (third precursor gas) and a catalyst as a third film-forming agent are supplied to the wafer 200 after performing step E, that is, the wafer 200 with the second inhibitor layer formed on the first surface.

Specifically, the valves 243b and 243d are opened to allow the third precursor and the catalyst to flow into the gas supply pipes 232b and 232d, respectively. The flow rates of the third precursor and the catalyst are adjusted by MFCs 241b and 241d, respectively, and the third precursor and the catalyst are supplied into the process chamber 201 via the nozzles 249b and 249a, mixed in the process chamber 201, and exhausted from the exhaust port 231a. In this operation, the precursor and the catalyst are supplied to the wafer 200 from the lateral side of the wafer 200 (third precursor+catalyst supply). At this time, the valves 243f to 243h may be opened to allow an inert gas to be supplied into the process chamber 201 via the nozzles 249a to 249c, respectively.

By supplying the third precursor and the catalyst to the wafer 200 under the process condition to be described later, it is possible to selectively chemisorb at least a portion of the molecular structure of molecules constituting the third precursor on the surface of the second film. As a result, a fifth layer is selectively formed on the second film. The fifth layer contains at least a portion of the molecular structure of the molecules constituting the precursor, which are residues derived from the third precursor. That is, the fifth layer contains at least some of atoms constituting the third precursor.

In this step, by supplying the catalyst together with the third precursor, it is possible to allow the above-described reaction to proceed in a non-plasma atmosphere and under a low temperature condition as will be described later, that is, at the third temperature. In this way, by forming the fifth layer in the non-plasma atmosphere and at the third temperature, it is possible to suppress invalidation and/or removal (desorption) of the second inhibitor layer formed on the first surface. The invalidation of the second inhibitor layer means that the molecular structure of the molecules constituting the second inhibitor layer, the arrangement structure of atoms constituting the second inhibitor layer, and the like are changed so as to enable the adsorption of the film-forming agent on the first surface or the reaction between the first surface and the film-forming agent.

Further, by forming the fifth layer in the non-plasma atmosphere and under the low temperature condition as will be described later, that is, at the third temperature, the third precursor can be prevented from being thermally decomposed (gas phase-decomposed), that is, autolyzed, in the process chamber 201. As a result, it is possible to prevent at least a portion of the molecular structure of molecules constituting the third precursor from multiple deposition on the first surface and the surface of the second film and selectively adsorb at least a portion of the molecular structure of molecules constituting the third precursor on the surface of the second film among the first surface and the surface of the second film.

Further, in this step, at least a portion of the molecular structure of the molecules constituting the third precursor may be adsorbed on a portion of the first surface of the wafer 200, but the adsorption amount thereof is very small and the amount of adsorption on the surface of the second film is overwhelmingly large. Such selective (preferential) adsorption is possible because the process condition in this step is the low temperature condition, as will be described later, that is, the third temperature, and the condition that the precursor does not undergo vapor phase decomposition in the process chamber 201. Further, this is also possible because the second inhibitor layer is formed over the entire region of the first surface, whereas the second inhibitor layer is not formed in many regions of the surface of the second film.

An example of the process conditions for supplying the third precursor and the catalyst in step F1 is described as follows.
Processing temperature (third temperature): room temperature (25 degrees C) to 200 degrees C, specifically room temperature to 150 degrees C
Processing pressure: 133 to 1,333 Pa
Processing time: 1 to 120 seconds, specifically 1 to 60 seconds
Third precursor supply flow rate: 0.001 to 2 slm
Catalyst supply flow rate: 0.001 to 2 slm
Inert gas supply flow rate (for each gas supply pipe): 0 to 20 slm

After selectively forming the fifth layer on the second film, the valves 243b and 243d are closed to stop the supply of the third precursor and the catalyst, respectively, into the process chamber 201. Then, a gaseous substance and the like remaining in the process chamber 201 are removed from the process chamber 201 (purging) according to the same processing procedure and process conditions as the purging in step G. It is desirable that the processing temperature for purging is the same as the processing temperature for supplying the third precursor and the catalyst.

As the third precursor, for example, the same Si- and halogen-containing gas (Si- and halogen-containing substance) as the various first precursors exemplified in step B 1 can be used. The third precursor and the first precursor may have different or same molecular structures. Further, the third precursor and the second precursor may have different or same molecular structures.

As the catalyst, for example, an amine-based gas (amine-based substance) containing C, N, and H can be used. As the amine-based gas (amine-based substance), a chain amine-based gas (chain amine-based substance) or a cyclic amine-based gas (cyclic amine-based substance) can be used. Examples of the catalyst may include chain amines such as triethylamine ((C₂H₅)₃N), diethylamine ((C₂H₅)₂NH), monoethylamine ((C₂H₅)NH₂), trimethylamine ((CH₃)₃N), dimethylamine ((CH₃)₂NH), and monomethylamine ((CH₃)NH₂). Further, examples of the catalyst may include cyclic amines such as aminopyridine (C₅H₆N₂), pyridine (C₅H₅N), picoline (C₆H₇N), lutidine (C₇H₉N), pyrimidine (C₄H₄N₂), quinoline (C₉H₇N), piperazine (C₄H₁₀N₂), piperidine (C₅H₁₁N), and aniline (C₆H₇N). In addition to these, for example, an NH₃ gas or the like can also be used as the catalyst. One or more of these may be used as the catalyst. This point also applies to step F2 which will be described later.

### [Step F2]

After step F 1 is completed, a third reactant (third reaction gas) and a catalyst (catalyst gas) as a third film-forming agent are supplied to the wafer 200, that is, the wafer 200 with the fifth layer selectively formed on the second film. Here, an example in which an oxidizing agent is used as the third reactant will be described.

Specifically, the valves 243c and 243d are opened to allow the third reactant and the catalyst to flow into the gas supply pipes 232c and 232d, respectively. The flow rates of the third reactant and the catalyst are adjusted by the MFCs 241c and 241d, respectively, and the third reactant and the catalyst are supplied into the process chamber 201 via the nozzles 249c and 249a, mixed in the process chamber 201, and exhausted from the exhaust port 231a. In this operation, the third reactant and the catalyst are supplied to the wafer 200 from the lateral side of the wafer 200 (third reactant+catalyst supply). At this time, the valves 243f to 243h may be opened to allow an inert gas to be supplied into the process chamber 201 via the nozzles 249a to 249c, respectively.

By supplying the third reactant and the catalyst to the wafer 200 under the process condition to be described later, it is possible to oxidize at least a portion of the fifth layer formed on the second film in step F1. As a result, a sixth layer formed by oxidizing the fifth layer is formed on the second film.

In this step, by supplying the catalyst together with the third reactant, it is possible to allow the above-described reaction to proceed in a non-plasma atmosphere and under a low temperature condition as will be described later, that is, at the third temperature. In this way, by forming the sixth layer in the non-plasma atmosphere and at the third temperature, it is possible to suppress invalidation and/or removal (desorption) of the second inhibitor layer formed on the first surface.

An example of the process condition for supplying the third reactant and the catalyst in step F2 is described as follows.
Processing temperature (first temperature): room temperature (25 degrees C) to 200 degrees C, specifically room temperature to 150 degrees C
Processing pressure: 133 to 1,333 Pa
Processing time: 1 to 120 seconds, specifically 1 to 60 seconds
Third reactant supply flow rate: 0.001 to 2 slm
Catalyst supply flow rate: 0.001 to 2 slm
Inert gas supply flow rate (for each gas supply pipe): 0 to 20 slm

After oxidizing the fifth layer formed on the second film, the valves 243c and 243d are closed to stop the supply of the third reactant and the catalyst, respectively, into the process chamber 201. Then, a gaseous substance and the like remaining in the process chamber 201 are removed from the process chamber 201 (purging) according to the same processing procedure and process conditions as the purging in step G. It is desirable that the processing temperature for purging is the same as the processing temperature for supplying the third reactant and the catalyst.

As the third reactant, for example, an oxidizing agent can be used. As the oxidizing agent, for example, an oxygen (O)- and H-containing gas can be used. Examples of the O- and H-containing gas may include gases having an O-H bond, such as water vapor (H₂O gas) and a hydrogen peroxide (H₂O₂) gas, a hydrogen (H₂) gas+oxygen (O₂) gas, a H₂ gas+ozone (O₃) gas, and the like. One or more of these gases may be used as the third reactant.

In the present disclosure, the description of two gases such as "H₂ gas+O₂ gas" together means a mixed gas of H₂ gas and O₂ gas. When supplying the mixed gas, the two gases may be mixed (pre-mixed) in a supply pipe and then supplied into the process chamber 201, or the two gases may be supplied separately from different supply pipes into the process chamber 201 and then mixed (post-mixed) in the process chamber 201.

As the catalyst, for example, the same catalyst as the various catalysts exemplified in the above-described step F1 can be used.

### [Performing Predetermined Number of Times]

By performing a cycle a predetermined number of times (m times, where m is an integer of 1 or 2 or more), the cycle including non-simultaneously, that is, non-synchronously, performing the above-described step F1 and step F2, it is possible to selectively (preferentially) form a third film on the first film formed on the second surface, as shown in FIG. 4G. For example, when the above-described third precursor, third reactant, and catalyst are used, it is possible to allow a SiO film or a silicon oxynitride film (SiOC film) as the third film to selectively grow on the second film. It is desirable that the above cycle is repeated a plurality of times. That is, the thickness of the sixth layer formed per cycle may be set to be smaller than a desired film thickness of the third film, and the above cycle may be repeated a plurality of times until the thickness of the third film formed by stacking sixth layers reaches the desired film thickness.

As described above, by performing the above cycle a plurality of times, it is possible to allow the third film to selectively grow on the second film. At this time, since the second inhibitor layer is formed on the first surface, it is possible to suppress the growth of the third film on the first surface. That is, by performing the above cycle a plurality of times, it is possible to promote the growth of the third film on the second film while suppressing the growth of the third film on the first surface.

Further, when performing step F 1 and step F2, the formation and growth of the third film on the first surface may occur very slightly. However, even in this case, the thickness of the third film formed on the first surface is much thinner than the thickness of the third film formed on the second film. As used herein, "selectively (preferentially) forming the third film on the second film" means to include not only a case where the third film is formed only on the second film with no third film formed on the first surface, but also a case where a very thin film is formed on the first surface but a much thicker film is formed on the second film.

### (Step H)

After performing step F, the wafer 200 is heat-treated (annealed). At this time, the output of the heater 207 is adjusted so that the internal temperature of the process chamber 201, that is, the temperature of the wafer 200 after performing step F, is equal to or higher than the third temperature. Desirably, the output of the heater 207 is adjusted so that the temperature of the wafer 200 after performing step F is higher than the third temperature.

By performing the heat treatment (annealing) to the wafer 200, impurities remaining in each of the first film, the second film, and the third film can be removed and defects can be repaired, thereby making the density of each of the first film, the second film, and the third film higher than before the heat treatment. As a result, each of the first film, the second film, and the third film can be made harder than those before the heat treatment. Thereby, the oxidation resistance of each of the first film, the second film, and the third film and the processing resistance of the films, that is, the etching resistance, can be improved. The annealing, that is, step H, may be omitted when the first film, the second film, and the third film do not require impurity removal, defect repair, film hardening, or the like.

Further, as shown in FIG. 4G, if the second inhibitor layer remains on the first surface of the wafer 200 after performing step F, by performing step H, the remaining second inhibitor layer can also be invalidated and/or removed by the heat treatment. For example, according to step H, it is also possible to remove the second inhibitor layer remaining on the first surface to expose the first surface, as shown in FIG. 4H.

Further, step H may be performed in a state where an inert gas is supplied into the process chamber 201, or may be performed in a state where a reactive substance such as an oxidizing agent (oxidizing gas) such as an O₂ gas, a nitriding agent (nitriding gas) such as an NH₃ gas, or a reducing agent (reducing gas) such as a H₂ gas is supplied into the process chamber 201. In this case, the inert gas and the reactive substance such as the oxidizing agent (oxidizing gas), the nitriding agent (nitriding gas), or the reducing agent (reducing gas) are also referred to as an assist substance.

An example of the process condition for heat treatment in step H is described as follows.
Processing temperature: 200 to 1,000 degrees C, specifically 400 to 700 degrees C
Processing pressure: 1 to 120,000 Pa
Processing time: 1 to 18,000 seconds
Assist substance supply flow rate: 0 to 50 slm

### (After-Purging and Returning to Atmospheric Pressure)

After step H is completed, an inert gas acting as a purge gas is supplied into the process chamber 201 from each of the nozzles 249a to 249c and is exhausted from the exhaust port 231a. Thus, the interior of the process chamber 201 is purged and a gas, reaction by-products, and the like remaining in the process chamber 201 are removed from the process chamber 201 (after-purging). After that, the internal atmosphere of the process chamber 201 is substituted with an inert gas (inert gas substitution) and the internal pressure of the process chamber 201 is returned to the atmospheric pressure (returning to atmospheric pressure).

### (Boat Unloading and Wafer Discharging)

After that, the seal cap 219 is moved down by the boat elevator 115 to open the lower end of the manifold 209. Then, the processed wafers 200 supported by the boat 217 are unloaded from the lower end of the manifold 209 to the outside of the reaction tube 203 (boat unloading). After the boat unloading, the shutter 219s is moved and the lower end opening of the manifold 209 is sealed by the shutter 219s via the O-ring 220c (shutter close). The processed wafers 200 are unloaded from the reaction tube 203 and are then discharged from the boat 217 (wafer discharging).

### (3) Effects of the Present Embodiment

According to the present embodiments, one or more effects set forth below may be achieved.

By performing step A, step B, and step C, it is possible to form the second film, which has the oxidation resistance higher than that of the first film, on the first film formed on the second surface among the first surface and the second surface, thereby making it possible to increase the oxidation resistance of the stacked film (stacked body) of the first film and the second film. This makes it possible to suppress the oxidation of the stacked film due to exposure to the atmosphere or the like and to suppress deterioration in the processing resistance (etching resistance) due to the oxidation of the stacked film. That is, the stacked film can maintain high etching resistance. As a result, when etching a film formed on the first surface by selective rupture in step D, it is possible to suppress the film reduction on the second surface due to etching of the stacked film. Moreover, since the stacked film has high resistance to oxidation and is hard to be oxidized, it is possible to leave many regions of the surface thereof in a non-OH-terminated state. That is, the stacked film can maintain a state in which the second inhibitor layer is hard to form on the surface of the stacked film. This makes it possible to selectively form the second inhibitor layer on the first surface when step E is performed after step D is performed. As a result, the second inhibitor layer can be selectively formed on the first surface among the first surface and the surface of the stacked film, thereby making it possible to selectively form the third film on the stacked film formed on the second surface. In this way, it is possible to selectively form a film on the second surface among the first surface and the second surface with high precision. Further, it is also possible to suppress deterioration of the electrical characteristics by improving the oxidation resistance of the stacked film.

By using the first precursor and the first reactant as the first film-forming agent in step B, the second precursor and the second reactant as the second film-forming agent in step C, and the third precursor, the third reactant, and the catalyst as the third film-forming agent in step F, it is possible to obtain the above-described effects efficiently and effectively. In particular, when the second precursor is a compound having a molecular structure different from that of the first precursor, it is possible to obtain the above-described effects more efficiently and effectively. In this case, since the thermal decomposition temperature of the second precursor is lower than the thermal decomposition temperature of the first precursor, it is possible to obtain the above-described effects further more efficiently and effectively.

When each of the first film and the second film contains atoms X, it is desirable that the first precursor contains one atom X in one molecule and the second precursor contains two or more atoms X in one molecule. In this case, it is desirable that the first precursor contains no chemical bond between X atoms and the second precursor contains a chemical bond between X atoms. These make it possible to obtain the above-described effects more efficiently and effectively.

It is desirable that the first precursor and the first reactant as the first film-forming agent are alternately supplied to the wafer 200 in step B, the second precursor and the second reactant as the second film-forming agent are alternately supplied to the wafer 200 in step C, and the third precursor, the third reactant, and the catalyst together with at least one of the third precursor and the third reactant as the third film-forming agent are alternately supplied to the wafer 200 in step F. As a result, it is possible to form a conformal stacked film on the wafer 200 with high uniformity.

It is desirable that the material of the second film is the same as that of the first film and the material of the third film is different from those of the first film and the second film. As a result, it is possible to selectively form the third film, which is made of the material different from that of the stacked film, on the stacked film of the first film and the second film which are selectively formed on the second surface and are made of the same material. It is desirable that the first film and the second film are nitride films and the third film is an oxide film. As a result, the above-described effects can be obtained more remarkably. Moreover, it is desirable that the first surface is a surface of an oxygen-containing film and the second surface is a surface of an oxygen-free film. Here, it is desirable that the oxygen-containing film is an oxide film and the oxygen-free film is a nitride film. Further, it is more desirable that the oxide film is a SiO film and the nitride film is a SiN film. As a result, the above-described effects can be obtained more remarkably.

### (4) Modifications

The processing sequence in the present embodiments can be changed as in the following modifications. These modifications can be used in proper combination. Unless otherwise stated, the processing procedure and process condition in each step of each modification can be the same as the processing procedure and process condition in each step of the above-described processing sequence.

### (Modification 1)

Step F may be modified as in the processing sequence shown below. That is, in step F, after alternately supplying the third precursor and the fourth reactant as the third film-forming agent to the wafer 200, an activated third reactant may be supplied to the wafer 200. That is, in step F in this modification, the third precursor, the third reactant, and the fourth reactant are used as the third film-forming agent. More specifically, in step F in this modification, the third film is formed on the second film on the first film formed on the second surface by performing a cycle a predetermined number of times (n₃ times, where n₃ is an integer of 1 or 2 or more), the cycle including a step of supplying the third precursor to the wafer 200 and a step of supplying the fourth reactant to the wafer 200, and then performing a step of supplying the activated third reactant to the wafer 200. As the activated third reactant, for example, the third reactant excited into a plasma state (in a plasma excited state) can be used. Note that the notation "third reactant*" in the following processing sequence means the third reactant excited into a plasma state.

First modifying agent -> (First precursor → First reactant) × n₁ → (Second precursor → Second reactant) × n₂ → Etching agent → Second modifying agent → [(Third precursor → Fourth reactant) × n₃ → Third reactant^{∗})] × m

Cleaning agent -> First modifying agent -> (First precursor → First reactant) × n₁ → (Second precursor → Second reactant) × n₂ → Etching agent -> Second modifying agent → [(Third precursor -> Fourth reactant) × n₃ -> Third reactant^{∗})] × m -> Heat treatment

The processing procedure and process condition of step F in this modification can be the same as the processing procedure and process condition of step B or step C in the above-described processing sequence except that the substances to be alternately supplied are the third precursor and the fourth reactant and that there is a step of exciting the third reactant into a plasma state and supplying it. Further, as the third precursor and the third reactant used in this modification, the same substances as the third precursor and the third reactant in the above-described embodiments can be used. That is, the third reactant used in this modification has a different molecular structure from the first reactant and the second reactant. Further, as the fourth reactant used in this modification, a substance having the same molecular structure as the first reactant and the second reactant can be used. For example, the same N-containing gas (N-containing substance) as the various first reactants exemplified in the above-described step B2 can be used as the fourth reactant used in this modification.

In step F in this modification, first, by alternately supplying the third precursor and the fourth reactant, it is possible to selectively (preferentially) form a precursor film on the second film on the first film formed on the second surface. For example, when using the above-described third source and fourth reactant, it is possible to allow a SiN film or a SiCN film as the precursor film to selectively grow on the second film. Thereafter, the precursor film can be oxidized (plasma-oxidized) by supplying the activated third reactant, that is, the third reactant excited into a plasma state, to the wafer 200 under the process condition to be described later. That is, in step F in this modification, a step of forming the precursor film by alternately supplying the third precursor and the fourth reactant and a step of oxidizing the precursor film by supplying the third reactant excited into a plasma state are performed. As a result, the precursor film can be changed into a third film having a composition different from that of the precursor film. Also in this modification, a third film similar to the third film in the above-described embodiment can be formed. In order to excite the third reactant into the plasma state, the above-described RPU 270 may be used. That is, the RPU 270 may excite the third reactant, which is supplied from the gas supply pipe 232c, into a plasma state, and may supply the third reactant, which is excited into the plasma state, into the process chamber 201.

An example of the process condition for exciting and supplying the third reactant to a plasma state in step F is described as follows.
Processing temperature: room temperature (25 degrees C) to 800 degrees C, specifically 500 to 750 degrees C
Processing pressure: 1 to 2,000 Pa, specifically 50 to 500 Pa
Processing time: 1 to 1,000 seconds, specifically 30 to 600 seconds
Third reactant supply flow rate: 0.1 to 10 slm
Inert gas supply flow rate (for each gas supply pipe): 0 to 20 slm
RF power: 1 to 5,000 W

Further, in this modification, the step of forming the precursor film in step F can be performed at the third temperature equal to or lower than the second temperature, or at the third temperature lower than the second temperature. By controlling the processing temperature as in this case, in the step of forming the precursor film in step F in this modification, the third energy equal to or lower than the second energy, which is imparted to at least a portion of the second film-forming agent (the second precursor and the second reactant), or the third energy lower than the second energy, which is imparted to at least a portion of the second film-forming agent (the second precursor and the second reactant), is imparted to at least a portion of the third film-forming agent (the third precursor and the fourth reactant). By doing so, it is possible to suppress invalidation and/or removal (desorption) of the second inhibitor layer formed on the first surface. This makes it possible to form the third film on the stacked film of the first film and the second film formed on the second surface, with higher selectivity.

This modification can also obtain the same effects as in the above-described embodiment. Further, in this modification, the step of oxidizing the precursor film in step F can be performed at a fourth temperature equal to or higher than the second temperature or t a fourth temperature higher than the second temperature. By controlling the processing temperature in this way, it is possible to form the third film with higher oxidation resistance and etching resistance. Further, when the precursor film is oxidized and changed into the third film, it is possible to remove impurities in the film, repair defects, and harden the film. Furthermore, after the step of forming the precursor film, the invalidation and/or removal (desorption) of the second inhibitor layer remaining on the first surface can be promoted. For example, it is also possible to remove the second inhibitor layer remaining on the first surface to expose the first surface.

### (Modification 2)

As in the processing sequence shown below, after performing step B and before performing step C, step I of removing the first film formed on the first surface by supplying an etching agent to the wafer 200 may be further included. In step B, the first film may be formed on the first surface due to selective rupture. For example, if step B is performed under the same process condition as step C, the first film may be formed on the first surface due to the selective rupture in step B. In this case, by performing step I, it is possible to remove (etch) the first film, which is formed on the first surface by selective rupture after performing step B, from the first surface. By doing so, in this modification, even if the selective rupture occurs in step B, it is possible to selectively form the first film on the second surface among the first surface and the second surface. In the case of this modification, after performing step I and before performing step C, by supplying the first modifying agent, which reacts with the first surface, to the wafer 200, it is desirable to perform step A' of forming the first inhibitor layer again on the first surface.

First modifying agent -> (First precursor → First reactant) × n₁ → Etching agent -> First modifying agent → (Second precursor → Second reactant) × n₂ → Etching agent -> Second modifying agent → (Third precursor + Catalyst → Third reactant + Catalyst) × m

Cleaning agent -> First modifying agent → (First precursor → First reactant) × n₁ → Etching agent → First modifying agent -> (Second precursor → Second reactant) × n₂ → Etching agent → Second modifying agent -> (Third precursor + Catalyst -> Third reactant + Catalyst) × m → Heat treatment

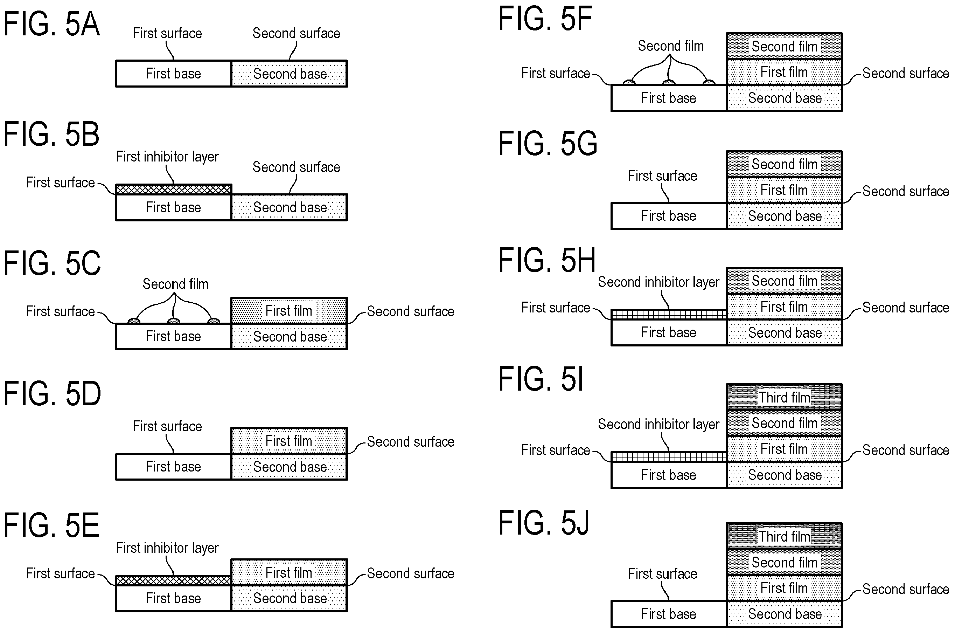

This modification will be described mainly with reference to FIGS. 5A to 5J. First, step G is performed to expose the first surface and the second surface of the wafer 200, as shown in FIG. 5A. Thereafter, step A is performed to selectively form the first inhibitor layer on the first surface, as shown in FIG. 5B. Thereafter, step B is performed to form the first film on the second surface, as shown in FIG. 5C. At this time, as shown in FIG. 5C, a first film thinner than the first film formed on the second surface is also locally formed on the first surface due to selective rupture. Thereafter, step I is performed to selectively remove the first film formed on the first surface, as shown in FIG. 5D. Subsequently, step A' is performed to selectively form the first inhibitor layer again on the first surface, as shown in FIG. 5E. Thereafter, step C is performed to selectively form the second film on the first film formed on the second surface, as shown in FIG. 5F. At this time, a second film thinner than the second film formed on the first film is also locally formed on the first surface, as shown in FIG. 5F. Thereafter, step D is performed to remove the second film formed on the first surface, as shown in FIG. 5G. Thereafter, step E is performed to selectively form the second inhibitor layer on the first surface, as shown in FIG. 5H. Next, step F is performed to form the third film on the second film on the first film formed on the second surface, as shown in FIG. 5I. Then, step H is performed to perform heat treatment to the wafer 200 including the first film, the second film, and the third film formed on the second surface, at which time the second inhibitor layer formed on the first surface is removed. In this way, as shown in FIG. 5J, a stacked film, which is formed by stacking the first film, the second film, and the third film, is formed only on the second surface among the first surface and the second surface.

The processing procedure and process condition of step I in this modification can be the same as the processing procedure and process condition of step D in the above-described processing sequence except that the object to which the etching agent is supplied is the wafer 200 subjected to step B. Further, the processing procedure and process condition of step A' in this modification can be the same as the processing procedure and process condition of step A in the above-described processing sequence except that the object to which the first modifying agent is supplied is the wafer 200 after performing step I.

Further, in this modification, step C can be performed at the second temperature equal to or higher than the first temperature. By controlling the processing temperature as in this case, in step C in this modification, the second energy equal to or higher than the first energy, which is imparted to at least a portion of the first film-forming agent (the first precursor, the first reactant), is imparted to at least a portion of the second film-forming agent (the second precursor, the second reactant). Therefore, the processing procedure and process condition of step C in this modification can be the same as the processing procedure and process condition of step C in the above-described processing sequence except that the second energy equal to or higher than the first energy, which is imparted to at least a portion of the first film-forming agent (the first precursor, the first reactant), is imparted to at least a portion of the second film-forming agent (the second precursor, the second reactant). By doing so, it is possible to form the second film, which has oxidation resistance equal to or higher than the oxidation resistance of the first film, on the first film formed on the second surface among the first surface and the second surface.

This modification can also obtain the same effects as in the above-described embodiment. Further, in this modification, since selective rupture is allowed in step B, step B can be performed at a higher processing temperature so as to form the first film having the same high oxidation resistance as the second film in the above-described embodiment. This makes it possible to form a stacked film (the stacked film of the first film and the second film) having higher oxidation resistance and etching resistance. Further, since the selective rupture caused in step B can be eliminated by step I, high selectivity can be ensured. Further, since the oxidation resistance and etching resistance of the first film can be increased, film reduction of the first film formed on the second surface due to the etching during step I can be suppressed. As a result, it is possible to selectively form a film having higher oxidation resistance and etching resistance on the second surface with higher precision. Further, in the case of this modification, the processing temperature (the first temperature) in step B and the processing temperature (the second temperature) in step C may be the same. This eliminates a need to change the processing temperature between step B and step C, which makes it possible to shorten the processing time.

### (Modification 3)

The above-described modification 1 and modification 2 may be combined as in the processing sequence shown below.

First modifying agent -> (First precursor → First reactant) × n₁ → Etching agent -> First modifying agent → (Second precursor → Second reactant) × n₂ → Etching agent -> Second modifying agent → [(Third precursor -> Fourth reactant) × n₃ → Third reactant*] × m

Cleaning agent -> First modifying agent -> (First precursor → First reactant) × n₁ → Etching agent → First modifying agent -> (Second precursor → Second reactant) × n₂ → Etching agent → Second modifying agent -> [(Third precursor -> Fourth reactant) × n₃ → Third reactant*] × m → Heat treatment

This modification can also obtain the same effects as in the above-described embodiment. Further, this modification can also obtain the same effects as in Modifications 1 and 2.

### (Modification 4)

In step C1, the second precursor having the same molecular structure as the first precursor may be used. That is, precursors having the same molecular structure may be used in steps B 1 and C1. If the molecular structures of the first precursor and the second precursor are the same, it is possible to reduce the kinds of substances used. As a result, the processing sequence can be simplified, so that the supply system in the substrate processing apparatus can be simplified and the apparatus cost can be reduced. This modification can also obtain the same effects as in the above-described embodiment.

### (Modification 5)

The inhibitor molecules constituting at least one selected from the group of the first inhibitor layer formed on the first surface in step A and the second inhibitor layer formed on the first surface in step E may contain at least one selected from the group of a fluorocarbon group and a fluorosilyl group. That is, at least one selected from the group of the first inhibitor layer and the second inhibitor layer, which are formed on the first surface, may include at least one selected from the group of fluorocarbon termination and silyl fluoride termination.

When the inhibitor molecule contains the fluorocarbon group, for example, the afore-mentioned compound, which has a structure in which an amino group and an alkyl group are directly bonded to Si, and the afore-mentioned F-containing gas can be used as the modifying agent (the first modifying agent and/or the second modifying agent), and these gases can be sequentially or simultaneously supplied to the wafer 200. Further, when the inhibitor molecule contains the fluorocarbon group, for example, a gas obtained by substituting some or all of H of the alkyl group with F in the aforementioned compound having a structure in which an amino group and an alkyl group are directly bonded to Si, may be used as the modifying agent (the first modifying agent and/or the second modifying agent). By at least one of these, at one selected from the group of the first inhibitor layer and the second inhibitor layer formed on the first surface includes a fluorocarbon termination.

Further, when the inhibitor molecule contains the fluorosilyl group, for example, the afore-mentioned compound, which has a structure in which an amino group is directly bonded to Si, and the afore-mentioned F-containing gas can be used as the modifying agent (the first modifying agent and/or the second modifying agent), and these gases can be sequentially or simultaneously supplied to the wafer 200. By at least one of these, at least one selected from the group of the first inhibitor layer and the second inhibitor layer formed on the first surface includes a fluorosilyl termination.

In this modification, an example of the process condition for supplying the compound having a structure in which an amino group and an alkyl group are directly bonded to Si or the compound having a structure in which an amino group is directly bonded to Si is described as follows.
Processing temperature: room temperature (25 degrees C) to 600 degrees C, specifically room temperature to 450 degrees C
Processing pressure: 1 to 2,000 Pa, specifically 1 to 1,000 Pa
Processing time: 1 second to 60 minutes
Compound supply flow rate: 0.001 to 2 slm, specifically 0.001 to 0.5 slm
Inert gas supply flow rate (for each gas supply pipe): 0 to 20 slm

In this modification, an example of the process condition for supplying the F-containing gas is described as follows.
Processing temperature: room temperature (25 degrees C) to 550 degrees C, specifically room temperature to 450 degrees C
Processing pressure: 1 to 2,000 Pa, specifically 1 to 1,000 Pa
Processing time: 1 second to 60 minutes
F-containing gas supply flow rate: 0.001 to 2 slm, specifically 0.001 to 0.5 slm
Inert gas supply flow rate (for each gas supply pipe): 0 to 20 slm

In any of these cases, since the outermost surface of at least one selected from the group of the first inhibitor layer and the second inhibitor layer becomes F, these can also be referred to as an F termination. The fluorocarbon group or fluorosilyl group, which terminates the first surface, can prevent the first film-forming agent (especially the first precursor), the second film-forming agent (especially the second precursor), and the third film-forming agent (especially the third precursor) from adsorption on the first surface in steps B, C, and F to thereby inhibit (suppress) the progress of the film-forming reaction on the first surface. This modification can also obtain the same effects as in the above-described embodiment.

### <Other Embodiments of the Present Disclosure>

The embodiments of the present disclosure have been specifically described above. However, the present disclosure is not limited to the above-described embodiments, and various changes can be made without departing from the gist thereof.

For example, the wafer 200 may include at least one selected from the group of an oxygen-containing film and a metal-containing film as the first surface (the first base), and may include at least one selected from the group of an oxygen-free film and a metal-free film as the second surface (the second base). Further, for example, the wafer 200 may have a plurality of types of regions having different materials as the first surface (the first base), and may have a plurality of types of regions having different materials as the second surface (the second base). The regions (the bases) constituting the first surface and the second surface may include, in addition to the above-mentioned SiO film and SiN film, films containing semiconductor elements, such as a silicon oxycarbonitride film (SiOCN film), a SiOC film, a silicon oxynitride film (SiON film), a SiCN film, a silicon carbide film (SiC film), a silicon borocarbonitride film (SiBCN film), a silicon boronitride film (SiBN film), a silicon borocarbide film (SiBC film), a silicon film (Si film), a germanium film (Ge film), and a silicon germanium film (SiGe film), films containing metal elements, such as a titanium nitride film (TiN film), a tantalum nitride film (TaN film), a tungsten film (W film), a molybdenum film (Mo film), a ruthenium film (Ru film), a cobalt film (Co film), a nickel film (Ni film), and a copper film (Cu film), an amorphous carbon film (a-C film), a single crystal Si (Si wafer), and the like. Any region (base) may be used as the first surface as long as it is a region (base) in which the first inhibitor layer and the second inhibitor layer can be formed. On the other hand, any region (base) may be used as the second surface as long as it is a region (base) on which the first inhibitor layer and the second inhibitor layer are difficult to be formed. This embodiment can also obtain the same effects as the above-described embodiment.

Further, for example, as the first film and the second film, in addition to the SiN film and the SiCN film, N-containing films containing semiconductor elements, such as a SiON film, a SiOCN film, a SiBCN film, a SiBN film, a germanium nitride film (GeN film), and a germanium oxynitride film (GeON film), and N-containing films containing metal elements, such as an aluminum nitride film (AlN film), a TiN film, a TaN film, and a tungsten nitride film (WN film), may be formed. When these films are formed, the same effects as in the above-described embodiment can be obtained. As long as the second film having higher oxidation resistance than the first film is formed on the first film, the first film and the second film may be films having at least a portion of different components, that is, films having different chemical compositions, that is, films made of different materials. In this case, depending on a combination of the material of the first film and the material of the second film, the above-described effects may be further enhanced.

Further, for example, as the third film, in addition to the SiO film and the SiOC film, O-containing films containing semiconductor elements, such as a SiOCN film, a SiON film, a germanium oxide film (GeO film), and a GeON film, and O-containing films containing metal elements, such as an aluminum oxide film (AlO film), a titanium oxide film (TiO film), a tantalum oxide film (TaO film), and a tungsten oxide film (WO film), may be formed. When these films are formed, the same effects as in the above-described embodiment can be obtained.

Recipes used in each process may be prepared individually according to the processing contents and may be stored in the memory 121c via a telecommunication line or the external memory 123. Moreover, at the beginning of each process, the CPU 121a may properly select an appropriate recipe from the recipes recorded and stored in the memory 121c according to the processing contents. Thus, it is possible for a single substrate processing apparatus to form films of various kinds, composition ratios, qualities, and thicknesses with enhanced reproducibility. Further, it is possible to reduce an operator's burden and to quickly start each process while avoiding an operation error.

The recipes mentioned above are not limited to newly-prepared ones but may be prepared, for example, by modifying existing recipes that are already installed in the substrate processing apparatus. Once the recipes are modified, the modified recipes may be installed in the substrate processing apparatus via a telecommunication line or a recording medium storing the recipes. In addition, the existing recipes already installed in the existing substrate processing apparatus may be directly modified by operating the input/output device 122 of the substrate processing apparatus.

An example in which a film is formed using a batch-type substrate processing apparatus capable of processing a plurality of substrates at a time has been described in the above-described embodiments. The present disclosure is not limited to the above-described embodiments, but may be suitably applied, for example, to a case where a film is formed using a single-wafer type substrate processing apparatus capable of processing a single substrate or several substrates at a time. In addition, an example in which a film is formed using a substrate processing apparatus provided with a hot-wall-type process furnace has been described in the above-described embodiments. The present disclosure is not limited to the above-described embodiments, but may be suitably applied to a case where a film is formed using a substrate processing apparatus provided with a cold-wall-type process furnace.

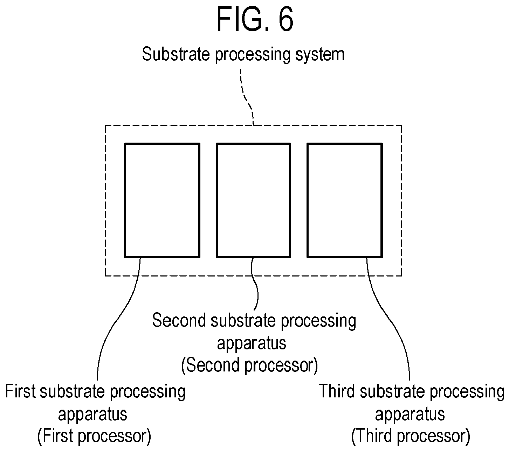

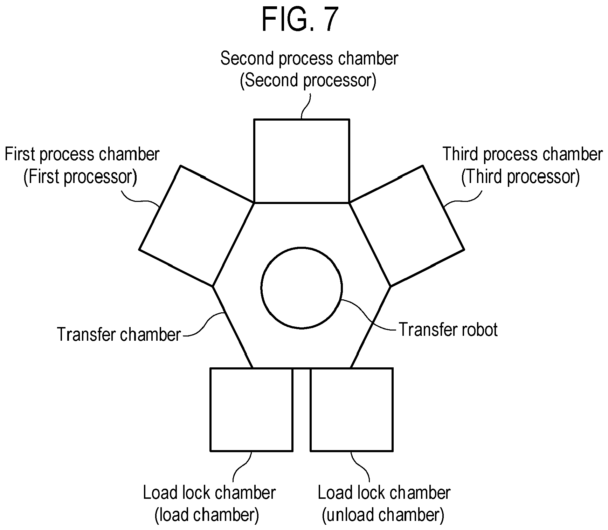

In the above-described embodiments, an example in which steps A to F are continuously performed in-situ in the same process chamber of the same substrate processing apparatus (substrate processing system) has been described. The present disclosure is not limited to the above-described embodiments, and may also be suitably applied to a case where, for example, as shown in FIG. 6, a substrate processing system including a plurality of stand-alone substrate processing apparatuses (a first substrate processing apparatus, a second substrate processing apparatus, and a third substrate processing apparatus) is used to perform each step ex-situ in different process chambers of respective different substrate processing apparatuses. In this case, for example, steps A to C can be performed in the first substrate processing apparatus, step D can be performed in the second substrate processing apparatus, and steps E to F can be performed in the third substrate processing apparatus. In this case, the first substrate processing apparatus, the second substrate processing apparatus, and the third substrate processing apparatus are also referred to as a first processor, a second processor, and a third processor, respectively. Further, the present disclosure may also be suitably applied to a case where, for example, as shown in FIG. 7, a substrate processing system including a cluster-type substrate processing apparatus provided with a plurality of process chambers (a first process chamber, a second process chamber, and a third process chamber) around a transfer chamber is used to perform each step in different process chambers of the same substrate processing apparatus. In this case, for example, steps A to C can be performed in the first process chamber, step D can be performed in the second process chamber, and steps E to F can be performed in the third process chamber. In this case, the first process chamber, the second process chamber, and the third process chamber are also referred to as a first processor, a second processor, and a third processor, respectively. The above-described embodiments can also be said to be an example in which the first processor, the second processor, and the third processor are the same processor.

Even in the case of using these substrate processing apparatuses, each process may be performed according to the same processing procedures and process condition as those in the above-described embodiments and modifications, and the same effects as the above-described embodiments and modifications can be obtained.

The above-described embodiments and modifications may be used in proper combination. The processing procedures and process condition used in this case may be the same as, for example, the processing procedures and process conditions in the above-described embodiments and modifications.

### [Examples]

### <Example 1>

An evaluation sample 1 of Example 1 in which the thickness of the first film (SiN film):the thickness of the second film (SiN film) = 3:1 was prepared by performing the same processing sequence as the above-described embodiment on a wafer having the same first surface and second surface as the above-described embodiment to laminate a SiN film as a first film, a SiN film as a second film, and a SiO film as a third film on the second surface. In addition, when preparing the evaluation sample 1, a plurality of evaluation samples 1 were prepared with the etching agent supply time in step D changed from 20 seconds to 240 seconds. The process condition in each step when preparing the evaluation sample 1 were set to predetermined condition within the range of the process condition in each step of the above-described embodiment. In addition, when preparing the evaluation sample 1, a chlorosilane-based gas, which does not contain a Si-Si bond exemplified in the above-described embodiment, was used as a first precursor, a chlorosilane-based gas, which contains a Si-Si bond exemplified in the above-described embodiment, was used as a second precursor, and a chlorosilane-based gas, which contains a Si-Si bond exemplified in the above-described embodiment, was used as a third precursor. In addition, a hydrogen nitride-based gas, which contains a N-H bond exemplified in the above-described embodiment, was used as a first reactant and a second reactant, and an O- and H-containing gas, which contains an O-H bond exemplified in the above-described embodiment, was used as a third reactant. In addition, a cyclic amine-based gas exemplified in the above-described embodiment was used as a catalyst.

### <Example 2>

An evaluation sample 2 of Example 2 in which the thickness of the first film (SiN film):the thickness of the second film (SiN film) = 5:3 was prepared by performing the same processing sequence as the above-described embodiment on a wafer having the same first surface and second surface as the above-described embodiment to laminate a SiN film as a first film, a SiN film as a second film, and a SiO film as a third film on the second surface. In addition, when preparing the evaluation sample 2, a plurality of evaluation samples 2 were prepared with the etching agent supply time in step D changed from 20 seconds to 240 seconds. The process conditions in each step when preparing the evaluation sample 2 were the same process conditions as in each step of Example 1 except for the cycle number in steps B and C. In addition, when preparing the evaluation sample 2, a first precursor, a second precursor, a third precursor, a first reactant, a second reactant, a third reactant, and a catalyst were all the same as those when preparing the evaluation sample 1.

### <Example 3>

An evaluation sample 3 of Example 3 in which the thickness of the first film (SiN film):the thickness of the second film (SiN film) = 1: 1 was prepared by performing the same processing sequence as the above-described embodiment on a wafer having the same first surface and second surface as the above-described embodiment to laminate a SiN film as a first film, a SiN film as a second film, and a SiO film as a third film on the second surface. In addition, when preparing the evaluation sample 3, a plurality of evaluation samples 3 were prepared with the etching agent supply time in step D changed from 20 seconds to 240 seconds. The process conditions in each step when preparing the evaluation sample 3 were the same process conditions as in each step of Example 1 except for the cycle number in steps B and C. In addition, when preparing the evaluation sample 3, a first precursor, a second precursor, a third precursor, a first reactant, a second reactant, a third reactant, and a catalyst were all the same as those when preparing the evaluation sample 1.

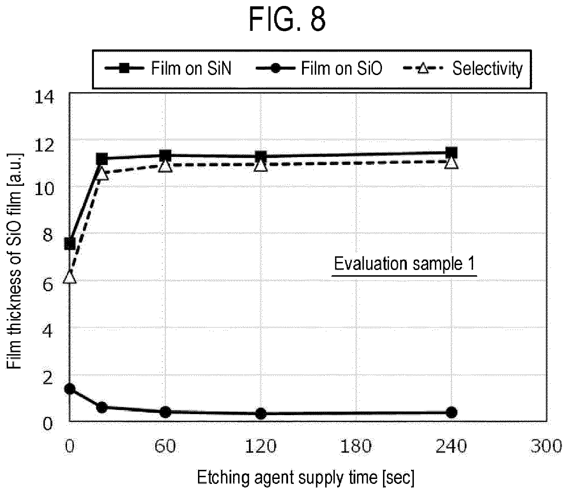

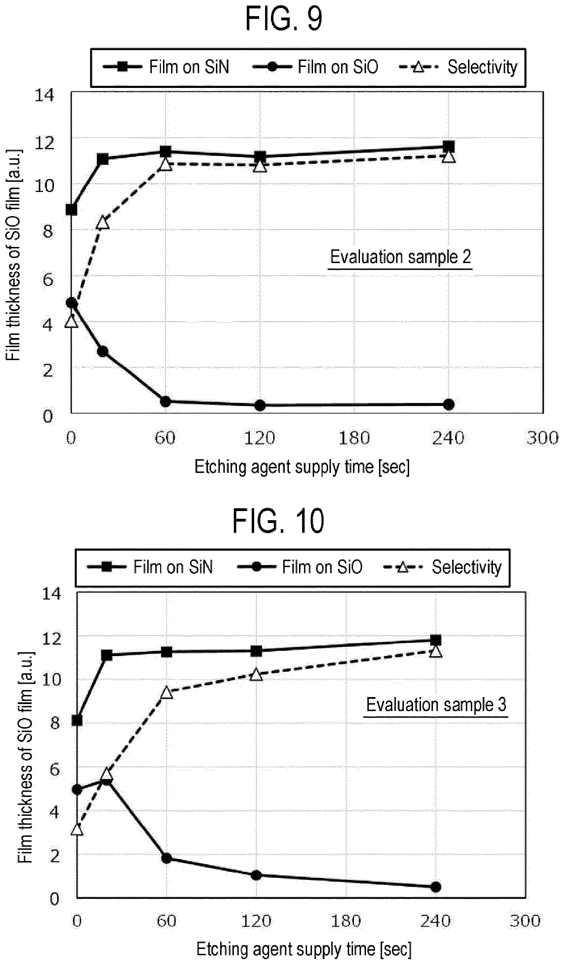

For each prepared evaluation sample, the thickness of the SiO film formed on the first surface and the thickness of the SiO film formed on the second surface were measured for each etching agent supply time in step D. In addition, selectivity was obtained from the measurement results by subtracting the thickness of the SiO film formed on the first surface from the thickness of the SiO film formed on the second surface. The larger the value of selectivity, the more precisely a film was selectively formed on the second surface. The results of the evaluation sample 1 are shown in FIG. 8, the results of the evaluation sample 2 are shown in FIG. 9, and the results of the evaluation sample 3 are shown in FIG. 10. In FIGS. 8 to 10, the horizontal axis represents the etching agent supply time (seconds), that is, the processing time, and the vertical axis represents the thickness of the SiO film (arbitrary unit: a.u.).

As is clear from FIGS. 8 to 10, in any of the evaluation samples 1 to 3, it is confirmed that by controlling the etching agent supply time in step D performed after performing steps B and C and before performing step E, a film can be formed on the second surface with high selectivity.

According to the present disclosure in some embodiments, it is possible to selectively form a film on a desired surface with high precision.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the disclosures. The accompanying claims and their equivalents are intended to cover such forms or modifications as would fall within the scope of the disclosures.

## Claims

1. A method of processing a substrate, comprising:
(a) forming a first inhibitor layer on a first surface of the substrate having the first surface and a second surface by supplying a first modifying agent, which reacts with the first surface, to the substrate;
(b) forming a first film on the second surface by supplying a first film-forming agent, in which a first energy is imparted to at least a portion of the first film-forming agent, to the substrate;
(c) forming a second film on the first film formed on the second surface by supplying a second film-forming agent, in which a second energy is imparted to at least a portion of the second film-forming agent, to the substrate, wherein a film including at least one selected from the group of the first film and the second film has been formed on the first surface;
(d) removing the film formed on the first surface by supplying an etching agent to the substrate;
(e) forming a second inhibitor layer on the first surface after the film has been removed, by supplying a second modifying agent, which reacts with the first surface, to the substrate; and
(f) forming a third film on the second film on the first film formed on the second surface by supplying a third film-forming agent, in which a third energy is imparted to at least a portion of the third film-forming agent, to the substrate.

2. The method of Claim 1, wherein in (b), a first precursor and a first reactant are used as the first film-forming agent,
wherein in (c), a second precursor and a second reactant are used as the second film-forming agent, and
wherein in (f), as the third film-forming agent, a third precursor and a third reactant are used, a third precursor, a third reactant, and a catalyst are used, or a third precursor, a third reactant, and a fourth reactant are used.

3. The method of Claim 2, wherein the second precursor has a different molecular structure from the first precursor.

4. The method of Claim 3, wherein a thermal decomposition temperature of the second precursor is lower than a thermal decomposition temperature of the first precursor.

5. The method of Claim 3, wherein each of the first film and the second film contains atoms X, the first precursor does not contain a chemical bond between the atoms X, and the second precursor contains a chemical bond between the atoms X.

6. The method of Claim 2, wherein the second precursor has a same molecular structure as the first precursor.

7. The method of Claim 2, wherein the first reactant, the second reactant, and the fourth reactant have a same molecular structure, and
wherein the first reactant and the third reactant have different molecular structures.

8. The method of Claim 2, wherein in (b), the first precursor and the first reactant are alternately supplied to the substrate,
wherein in (c), the second precursor and the second reactant are alternately supplied to the substrate, and
wherein in (f), the third precursor and the third reactant are alternately supplied to the substrate, the third precursor and the third reactant are alternately supplied to the substrate and the catalyst is supplied together with at least one selected from the group of the third precursor and the third reactant, or the third precursor and the fourth reactant are alternately supplied to the substrate and then the third reactant, which is activated, is supplied to the substrate.

9. The method of any one of Claims 1 to 8, wherein in (b), the first film is formed on the first surface, and
wherein the method further comprises: after performing (b) and before performing (c), removing the first film formed on the first surface by supplying an etching agent to the substrate.

10. The method of any one of Claims 1 to 8, wherein the second energy is an energy equal to or higher than the first energy, or an energy higher than the first energy.

11. The method of any one of Claims 1 to 8, wherein the third energy is an energy equal to or lower than the second energy, or an energy lower than the second energy.

12. The method of any one of Claims 1 to 8, wherein the second film is made of a same material as the first film, and the third film is made of a different material from the first film and the second film.

13. A method of manufacturing a semiconductor device, comprising the method of Claim 1.

14. A substrate processing system comprising:
a first processor that is capable of performing:
(a) forming a first inhibitor layer on a first surface of a substrate having the first surface and a second surface by supplying a first modifying agent, which reacts with the first surface, to the substrate;
(b) forming a first film on the second surface by supplying a first film-forming agent, in which a first energy is imparted to at least a portion of the first film-forming agent, to the substrate; and
(c) forming a second film on the first film formed on the second surface by supplying a second film-forming agent, in which a second energy is imparted to at least a portion of the second film-forming agent, to the substrate, wherein a film including at least one selected from the group of the first film and the second film has been formed on the first surface;
a second processor that is capable of performing (d) removing the film formed on the first surface by supplying an etching agent to the substrate; and
a third processor that is capable of performing:
(e) forming a second inhibitor layer on the first surface after the film has been removed, by supplying a second modifying agent, which reacts with the first surface, to the substrate; and
(f) forming a third film on the second film on the first film formed on the second surface by supplying a third film-forming agent, in which a third energy is imparted to at least a portion of the third film-forming agent, to the substrate.

15. A program that causes, by a computer, a substrate processing system to perform a process comprising:
(a) forming a first inhibitor layer on a first surface of a substrate having the first surface and a second surface by supplying a first modifying agent, which reacts with the first surface, to the substrate;
(b) forming a first film on the second surface by supplying a first film-forming agent, in which a first energy is imparted to at least a portion of the first film-forming agent, to the substrate;
(c) forming a second film on the first film formed on the second surface by supplying a second film-forming agent, in which a second energy is imparted to at least a portion of the second film-forming agent, to the substrate, wherein a film including at least one selected from the group of the first film and the second film has been formed on the first surface;
(d) removing the film formed on the first surface by supplying an etching agent to the substrate;
(e) forming a second inhibitor layer on the first surface after the film has been removed, by supplying a second modifying agent, which reacts with the first surface, to the substrate; and
(f) forming a third film on the second film on the first film formed on the second surface by supplying a third film-forming agent, in which a third energy is imparted to at least a portion of the third film-forming agent, to the substrate.
